# EUROPEAN PATENT SPECIFICATION

(11) **EP 3 681 145 B1**
(45) Date of publication and mention of the grant of the patent: **20.03.2024**
(21) Application number: 18853816.9
(22) Date of filing: 06.09.2018
(51) Int. Cl.: H04N 25/443, H04N 25/75

(54) **SOLID-STATE IMAGING DEVICE, CONTROL METHOD AND DRIVE METHOD THEREFOR, AND ELECTRONIC EQUIPMENT**
FESTKÖRPERBILDGEBUNGSVORRICHTUNG, STEUERUNGSVERFAHREN UND ANSTEUERUNGSVERFAHREN DAFÜR UND ELEKTRONISCHE AUSRÜSTUNG
DISPOSITIF D'IMAGERIE À SEMICONDUCTEUR, PROCÉDÉ DE COMMANDE ET PROCÉDÉ DE PILOTAGE DE CELUI-CI, ET ÉQUIPEMENT ÉLECTRONIQUE

(30) Priority: 06.09.2017 US 201762554936 P
(43) Date of publication of application: 15.07.2020
(73) Proprietor: Sony Semiconductor Solutions Corporation, Atsugi-shi, Kanagawa 243-0014 (JP)
(72) Inventor: ANAS, Bostamam, Atsugi-shi Kanagawa 243-0014 (JP); HANZAWA, Katsuhiko, Park Ridge New Jersey 07656 (US)
(74) Representative: Müller Hoffmann & Partner
(86) International application number: PCT/JP2018/033007
(87) International publication number: WO 2019/049923

(56) References cited:
- JP-A- 2010 161 651
- JP-A- 2012 165 168
- JP-A- 2012 175 234
- JP-A- 2016 184 843
- US-A1- 2006 274 177
- US-A1- 2009 086 077
- US-A1- 2012 199 724
- US-A1- 2014 118 592

## Description

### [Technical Field]

The present disclosure relates to a solid-state imaging apparatus, a method of controlling the solid-state imaging apparatus, a method of driving the solid-state imaging apparatus, and an electronic device. More particularly, the disclosure relates to a solid-state imaging apparatus capable of saving on power consumption, a method of controlling the solid-state imaging apparatus, a method of driving the solid-state imaging apparatus, and an electronic device.

### [Background Art]

In the past, there have been known CMOS image sensors operating by a column AD method aimed at boosting readout speed by parallelly operating AD conversion parts each provided for each of pixel columns.

With the CMOS image sensors operating by the column AD method in an imaging mode such as one in which thinning-out readout is performed or one in which ROI readout is carried out, only part of the columns are targeted for readout but all columns are operated. This has led to a waste of power.

In this respect, PTL 1 discloses a configuration that, at the time of thinning-out readout, provides on/off switching of currents on the vertical signal lines of the columns not targeted for readout with a view to saving on power consumption.

Also, PTL 2 discloses a configuration that, at the time of ROI readout, permits control of the readout of a partial range of the pixel columns in order to save on power consumption.
US 2009/0086077 A1 discloses a A solid-state image capture apparatus that includes a pixel array section with a plurality of pixels arranged in two-dimensional directions, each having a photoelectric conversion section, and pixel drive control section for performing pixel signal readout by sequentially scanning the pixel array section either in a row direction or in a column direction, and driving and controlling individual pixels of the pixel array section through a level shifter circuit. The pixel drive control means includes thinning-out readout control means for performing pixel signal readout, reset control means for resetting either a non-readout pixel row or a non-readout pixel column not being selected by the thinning-out readout control means and gate means for causing the pixel drive control means to perform driving control, whereby current concurrently flowing into the level shifter circuit during the thinning-out readout driving, may be avoided and large current caused by the level shifter circuit may be suppressed.
US 2006/0274177 A1 discloses an image processing apparatus that includes: an image pickup device that performs a resolution conversion imaging operation of performing imaging on all pixel areas with a resolution, which is lower than a resolution that the image pickup device has, and a partial imaging operation of performing imaging on a region limited to a part of all pixel areas; and an image processing circuit that performs computation on stored image data, and that has a moving body detection function of detecting a region, in which a moving body may be present, from resolution conversion imaging images obtained at different moments, and also has a face detection function of detecting an area, which may represent a face of a person, according to partial image data obtained by a partial imaging operation performed by the image pickup device on the region detected by the moving body detection function. Document US 2014/118592 A1 discloses a CMOS sensor which includes a pixel array and pixel processing circuitry used for motion sensing, feature extraction, and image capture.

### [Citation List]

### [Patent Literature]

[PTL 1]
   Japanese Patent Laid-open No. 2007-142738
[PTL 2]
   Japanese Patent Laid-open No. 2012-165168

### [Summary]

### [Technical Problem]

However, the configuration of PTL 1 is incapable of region clipping. The configuration of PTL 2 has no capability of thinning-out readout. That is, these configurations cannot save on power consumption without recourse to readout modes.

The present disclosure has been devised in view of the above circumstances and proposes saving on power consumption.

### [Solution to Problem]

The invention is defined by the appended claims. References to embodiments which do not fall under the scope of the claims are to be understood as examples useful for understanding the invention.

According to a first aspect of the present disclosure, there is provided a solid-state imaging apparatus according to claim 1.

According to a second aspect of the present disclosure, there is provided a method of driving a solid-state imaging according to claim 11.

### [Brief Description of Drawings]

[FIG. 1]

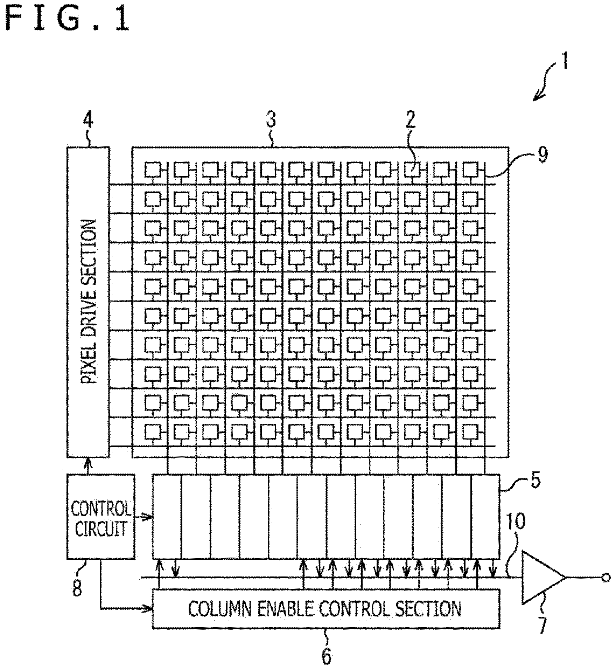

   FIG. 1 is a block diagram depicting an exemplary configuration of a solid-state imaging apparatus according to the present disclosure.
[FIG. 2]

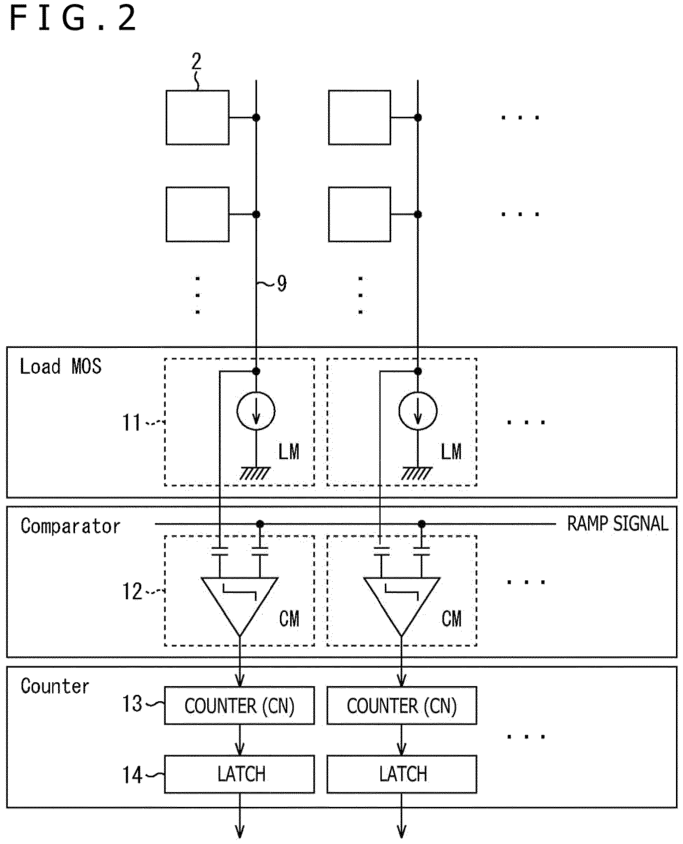

   FIG. 2 is a block diagram block diagram depicting an exemplary configuration of a column AD section.
[FIG. 3]

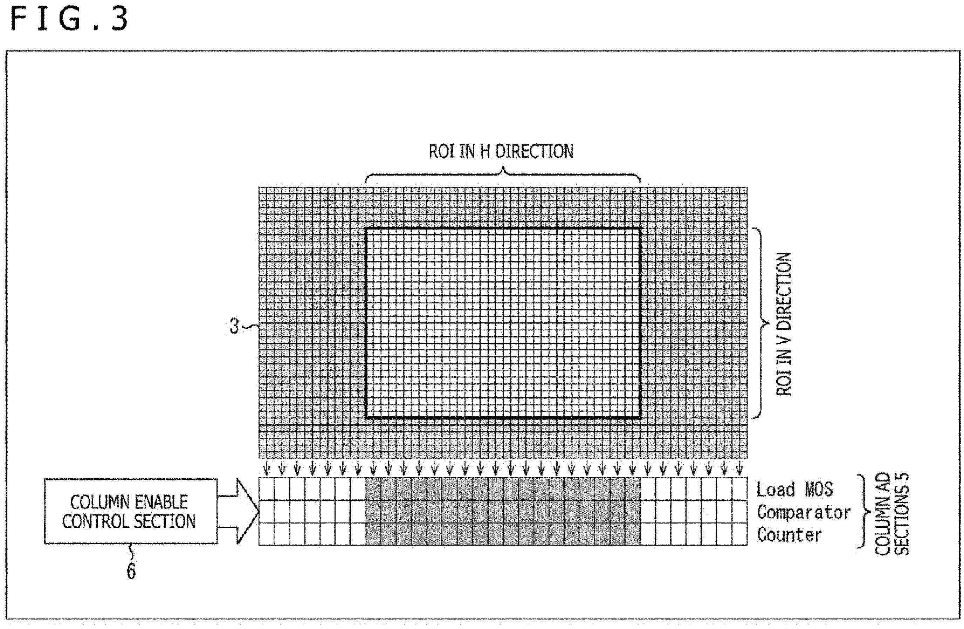

   FIG. 3 is a view explaining column operations at the time of ROI readout.
[FIG. 4]

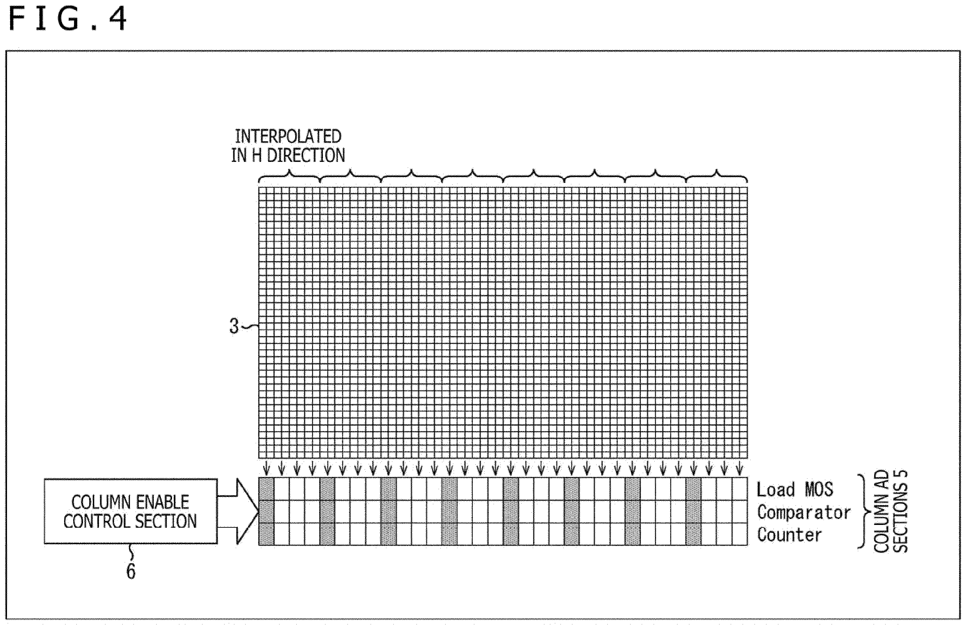

   FIG. 4 is a view explaining column operations at the time of H direction interpolation readout.
[FIG. 5]

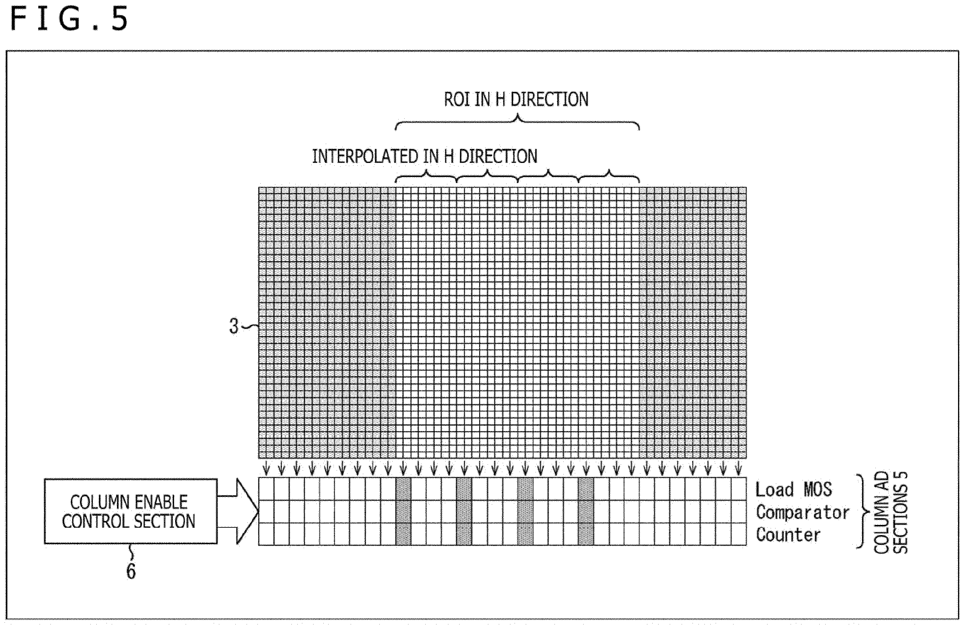

   FIG. 5 is a view explaining column operations at the time of H direction ROI readout plus H direction interpolation readout.
[FIG. 6]

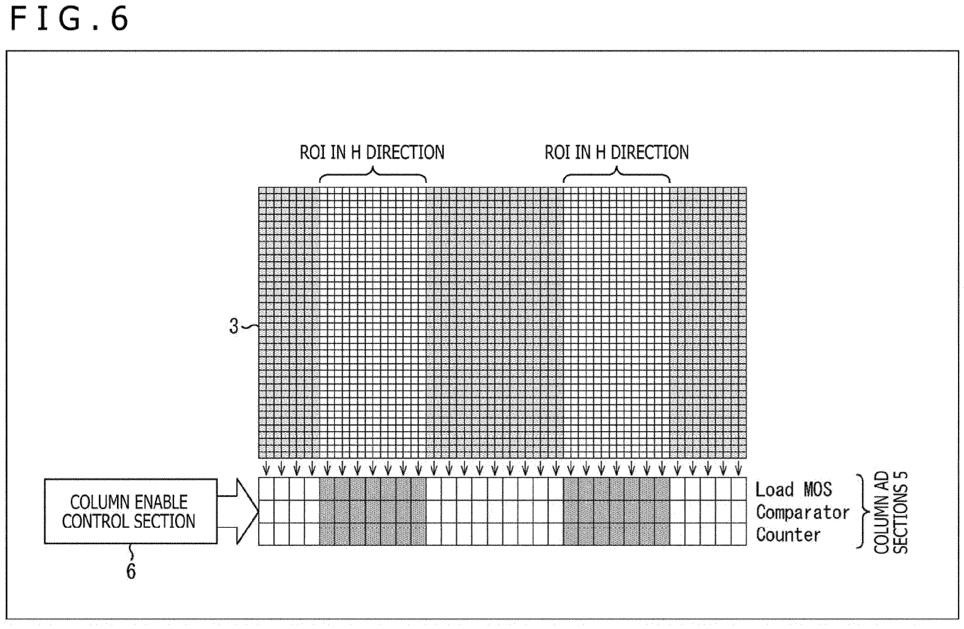

   FIG. 6 is a view explaining column operations at the time of H direction multiple ROI readout.
[FIG. 7]

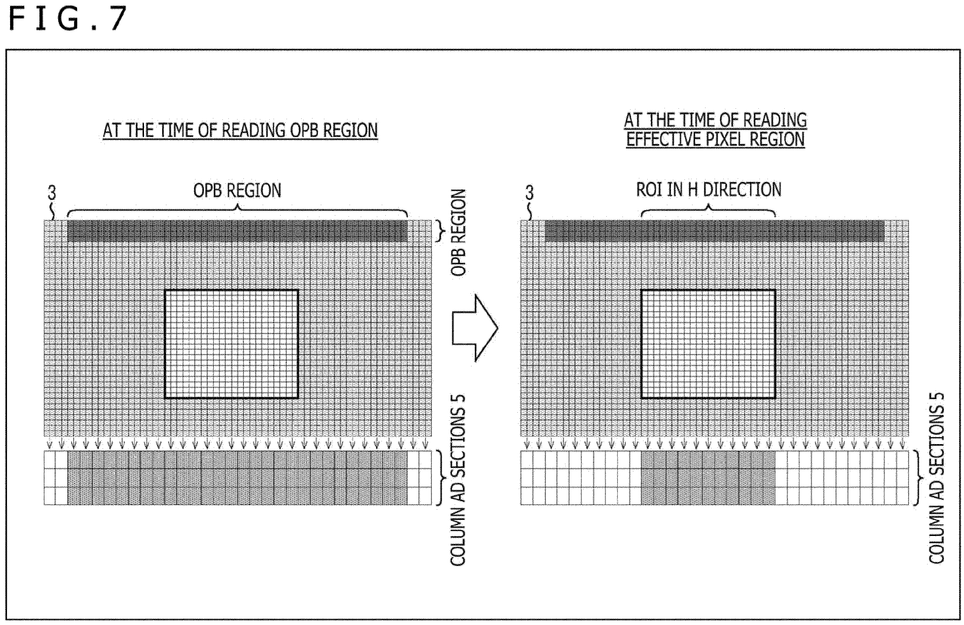

   FIG. 7 is a view explaining column operations in accordance with read rows.
[FIG. 8]

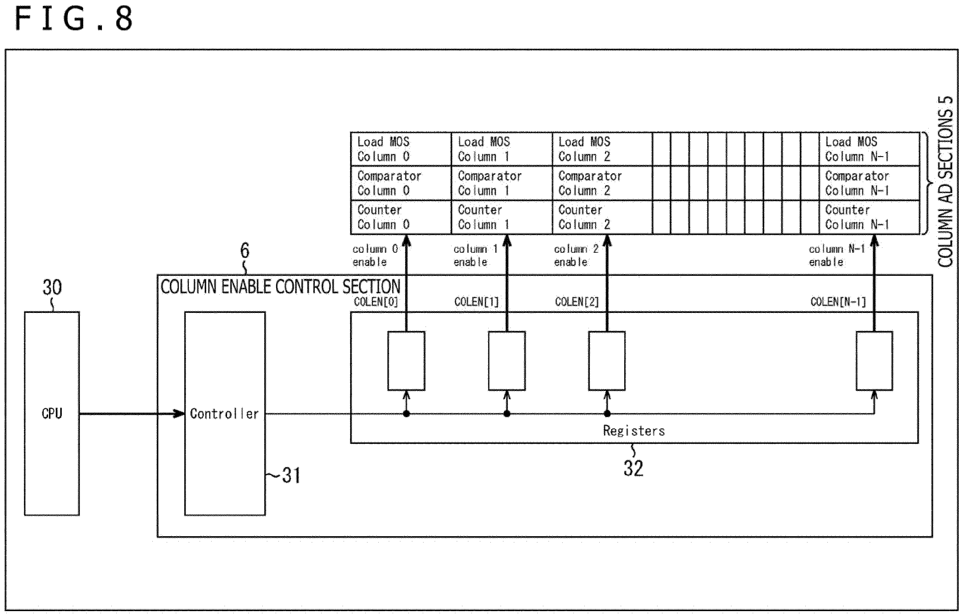

   FIG. 8 is a block diagram depicting an exemplary configuration of a column enable control section.
[FIG. 9]

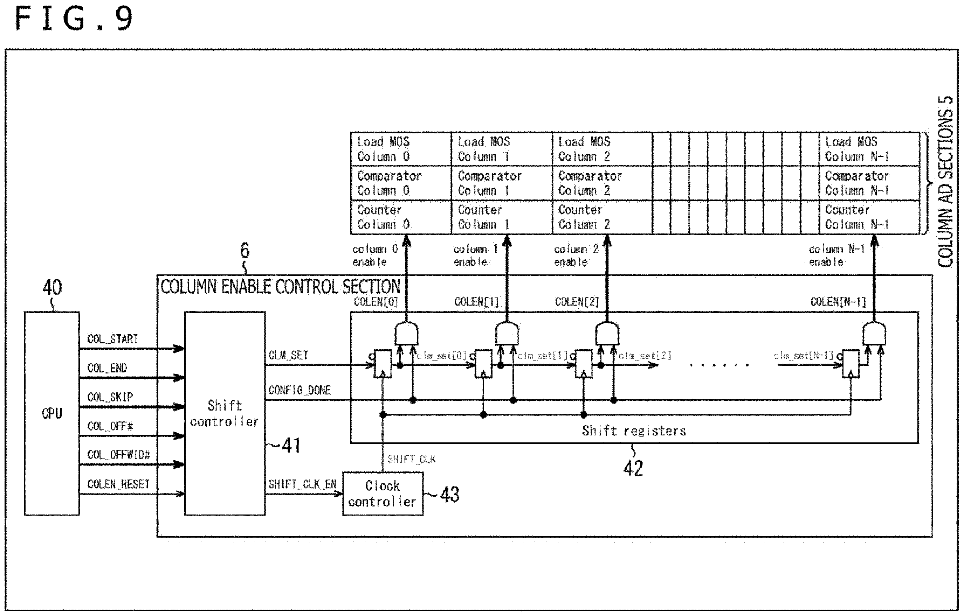

   FIG. 9 is a block diagram depicting a first exemplary implementation of the column enable control section.
[FIG. 10]

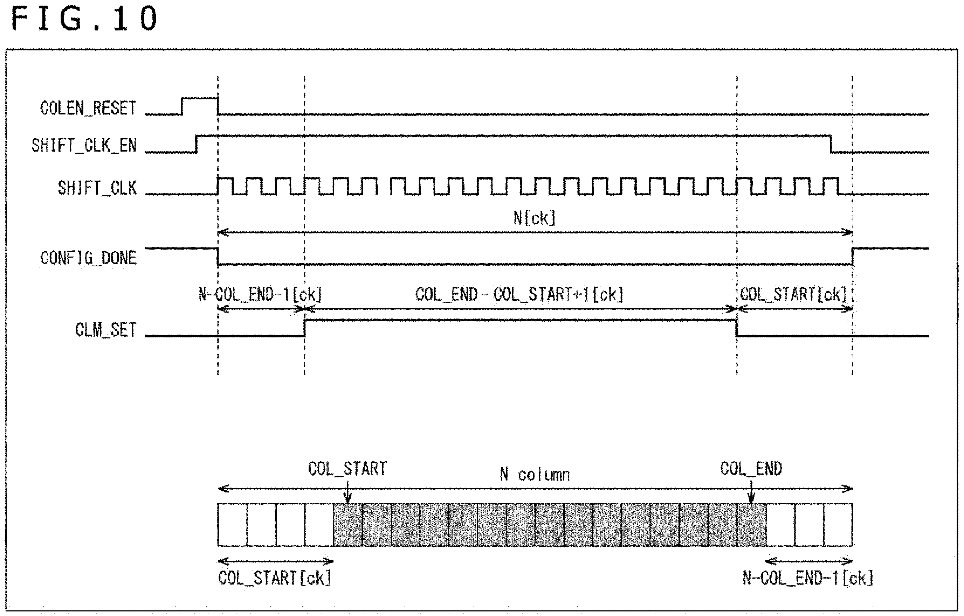

   FIG. 10 is a timing chart depicting operations of the column enable control section.
[FIG. 11]

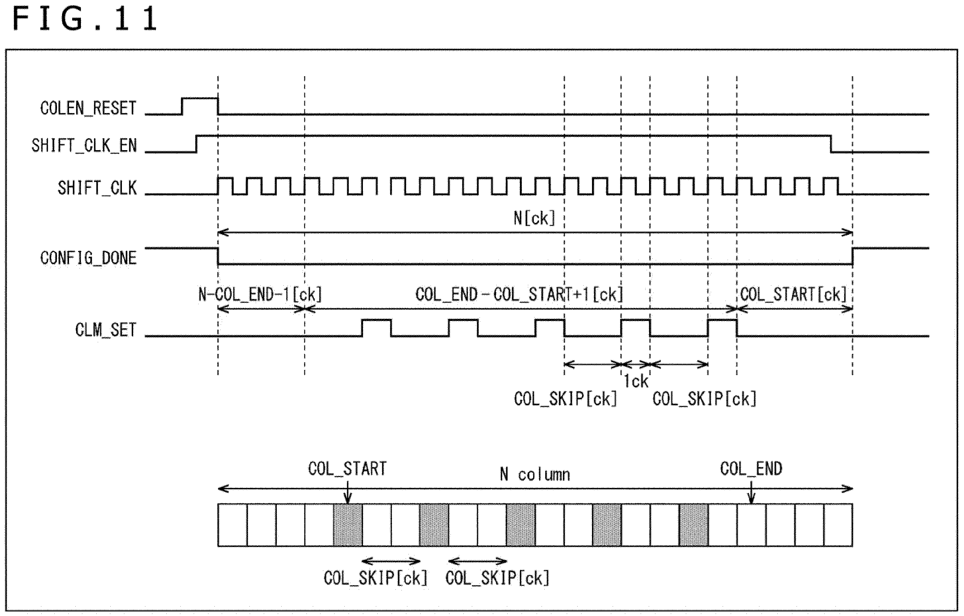

   FIG. 11 is a timing chart depicting other operations of the column enable control section.
[FIG. 12]

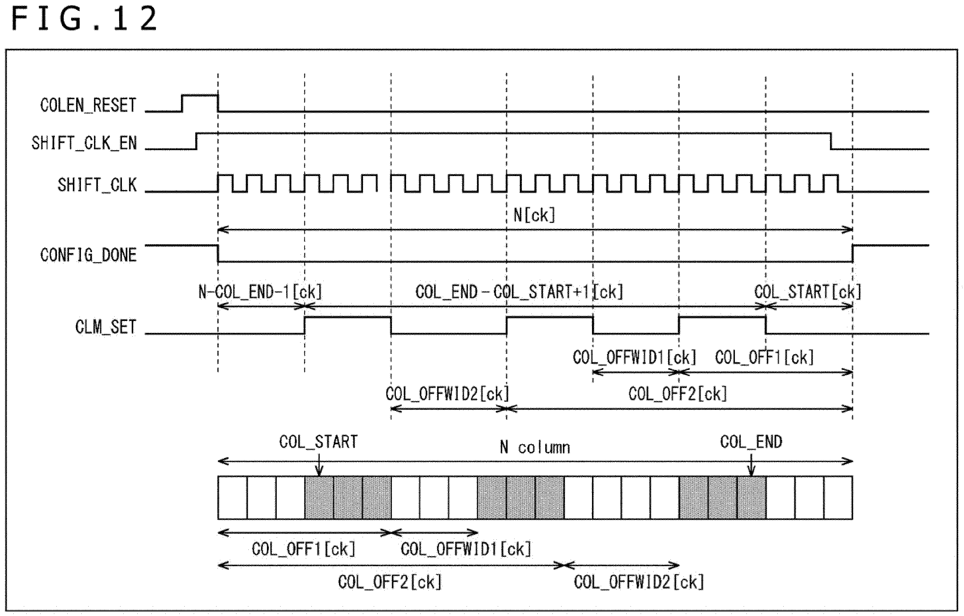

   FIG. 12 is a timing chart depicting other operations of the column enable control section.
[FIG. 13]

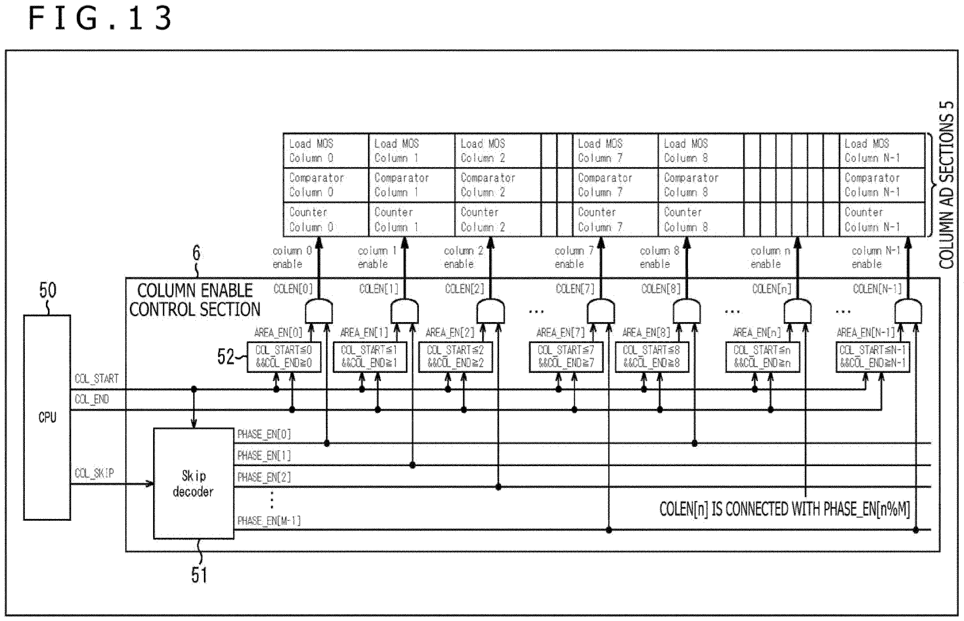

   FIG. 13 is a block diagram depicting a second exemplary implementation of the column enable control section.
[FIG. 14]

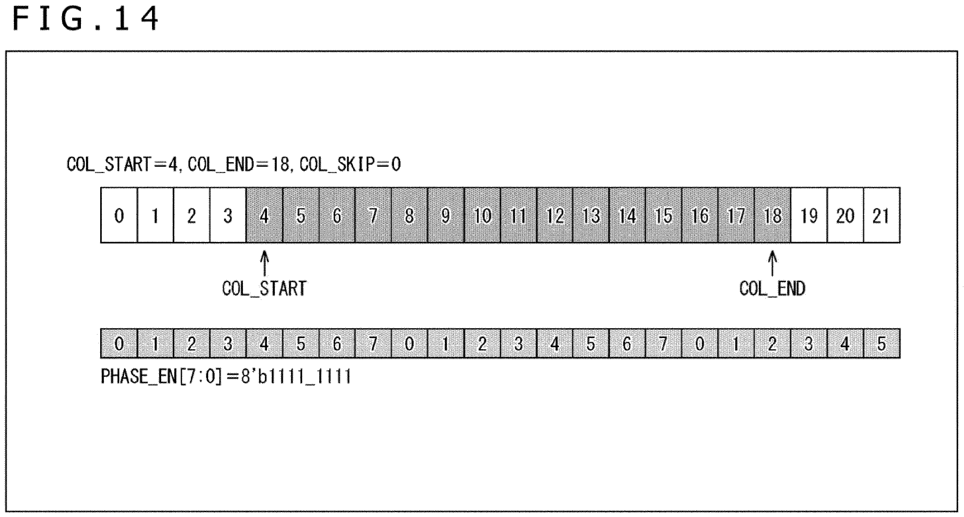

   FIG. 14 is a view explaining operations of the column enable control section.
[FIG. 15]

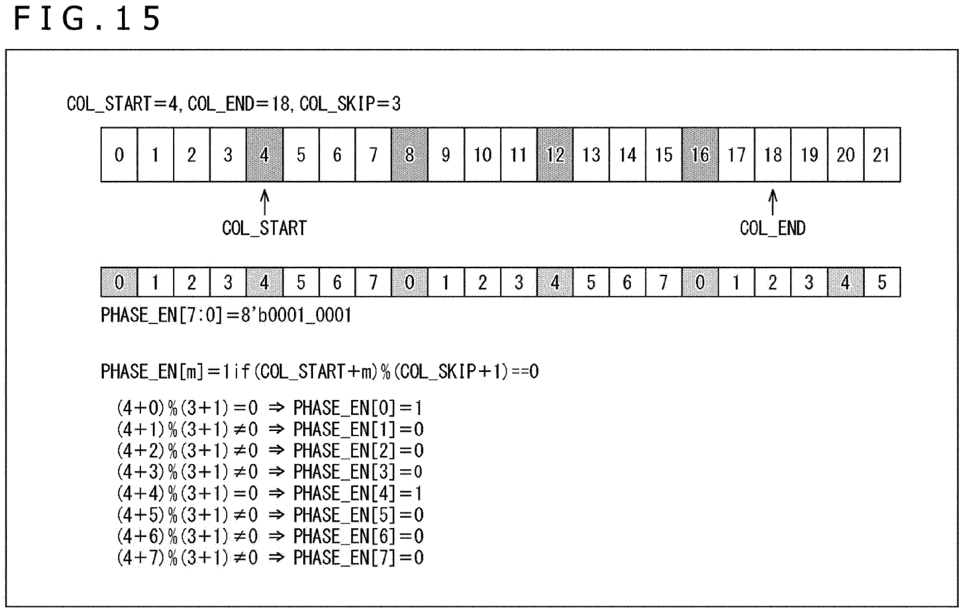

   FIG. 15 is a view explaining other operations of the column enable control section.
[FIG. 16]

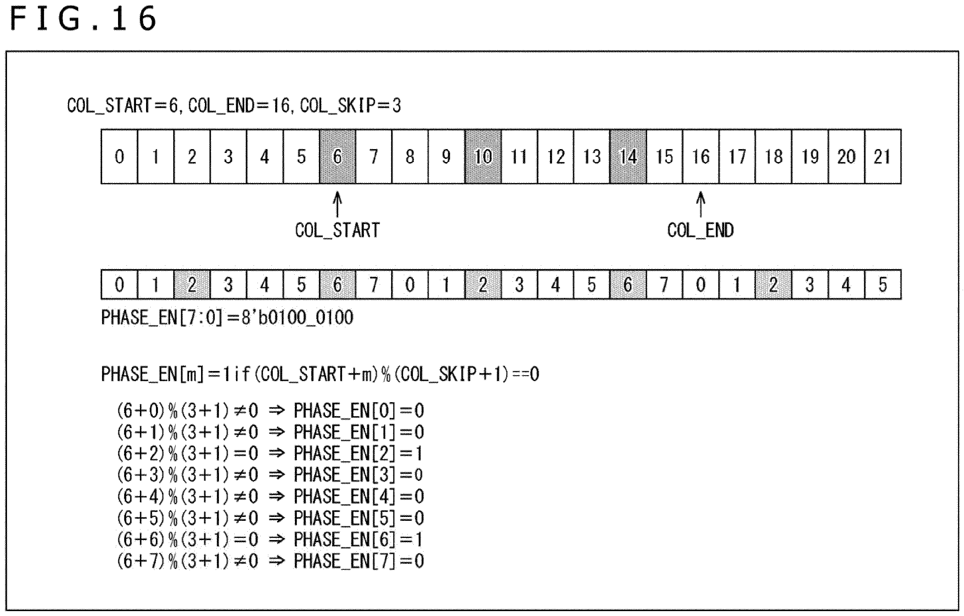

   FIG. 16 is a view explaining other operations of the column enable control section.
[FIG. 17]

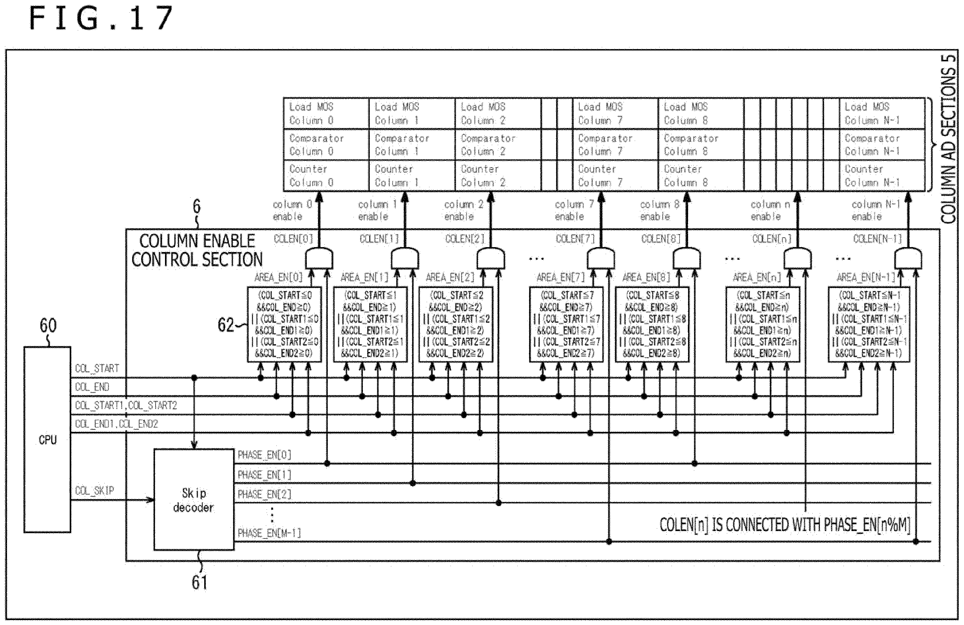

   FIG. 17 is a block diagram depicting a third exemplary implementation of the column enable control section.
[FIG. 18]

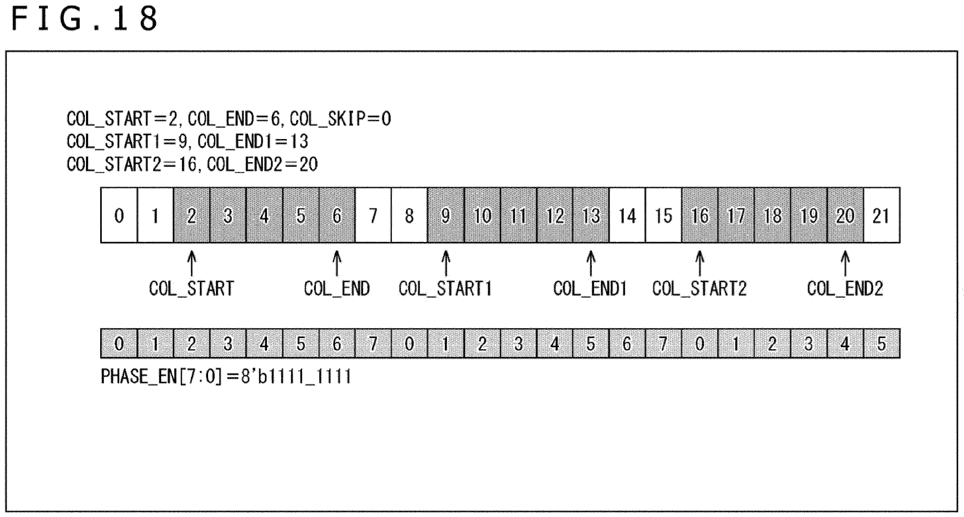

   FIG. 18 is a view explaining operations of the column enable control section.
[FIG. 19]

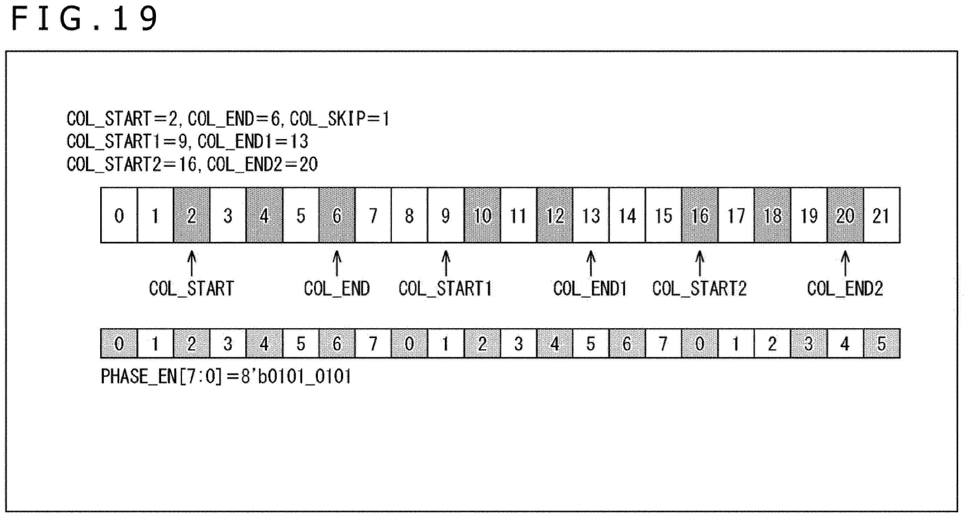

   FIG. 19 is a view explaining other operations of the column enable control section.
[FIG. 20]

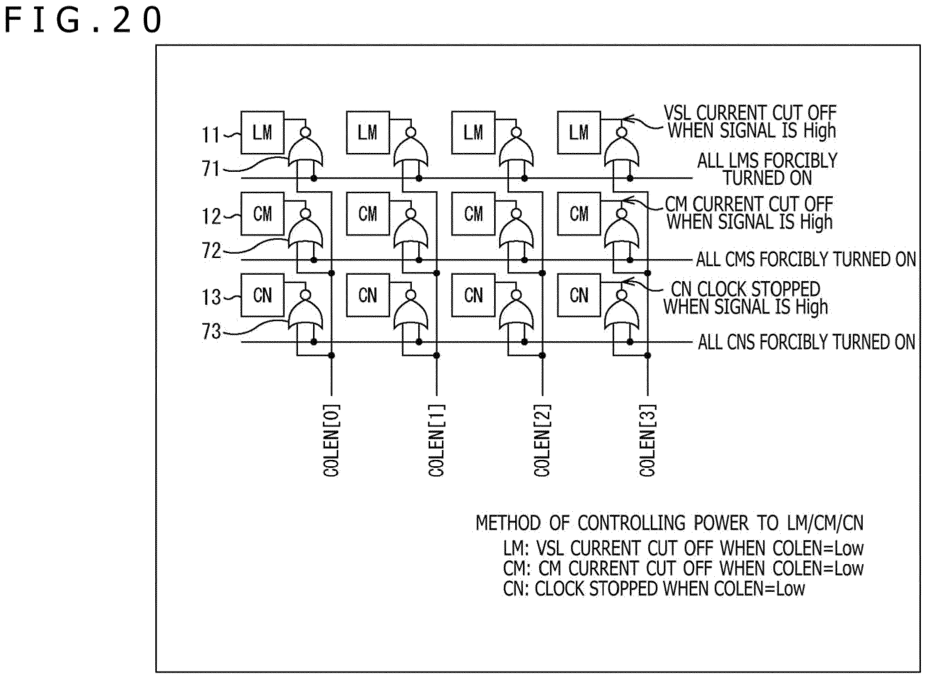

   FIG. 20 is a view explaining a method of controlling power to the column AD sections.
[FIG. 21]

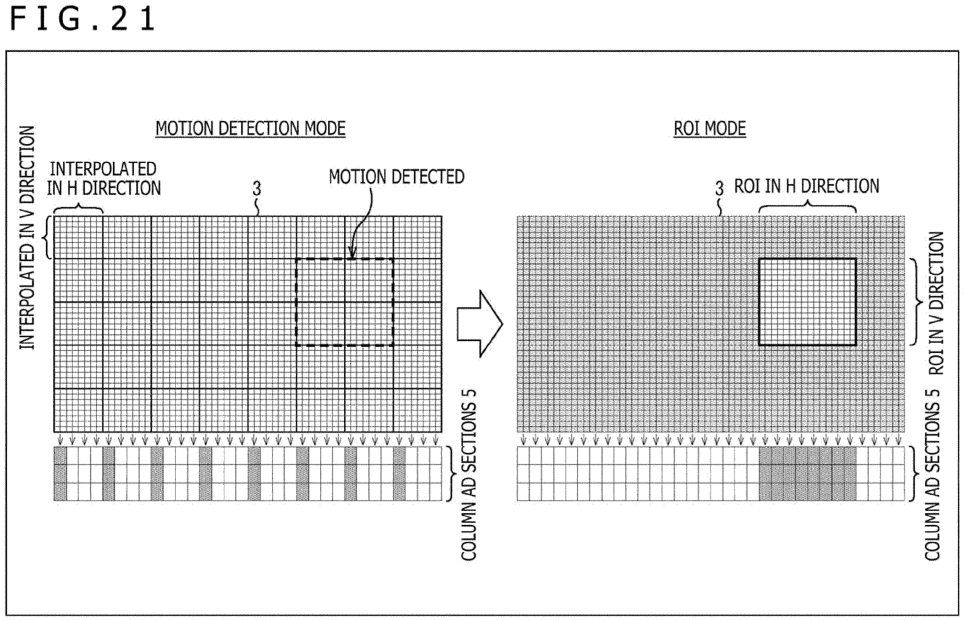

   FIG. 21 is a view explaining an example of use in a surveillance camera.
[FIG. 22]

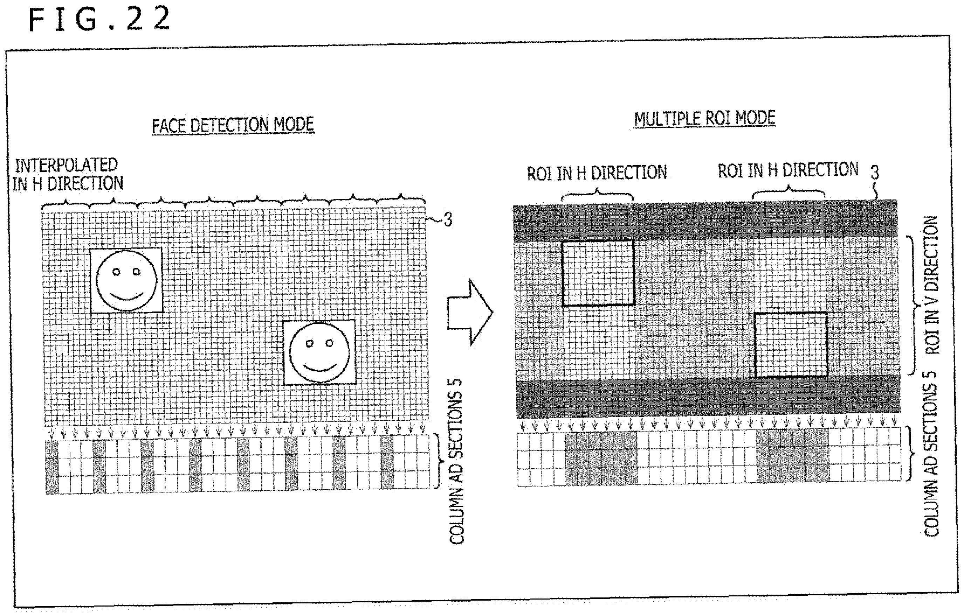

   FIG. 22 is a view explaining another example of use in the surveillance camera.
[FIG. 23]

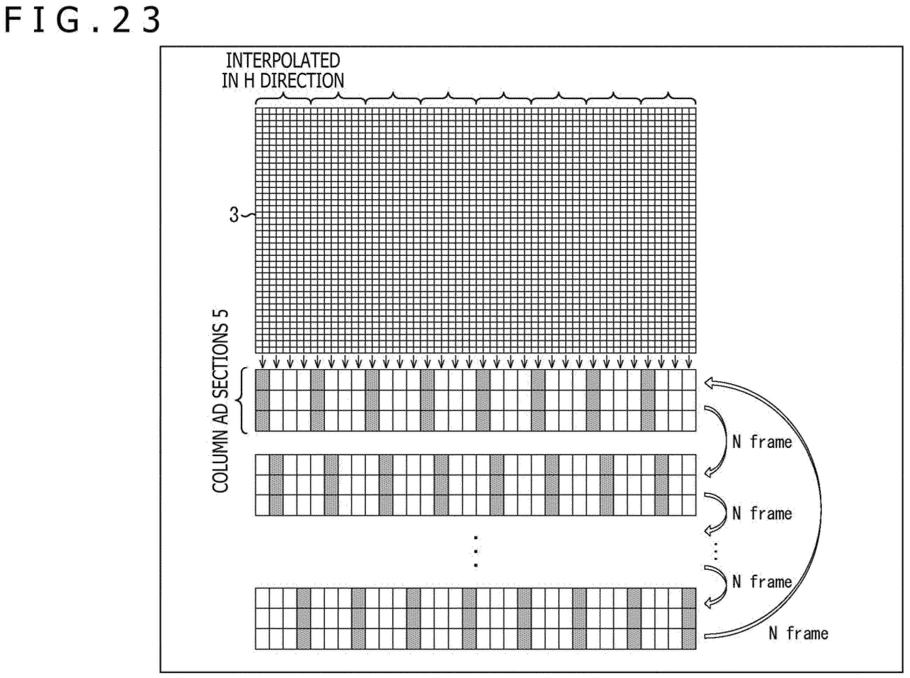

   FIG. 23 is a view explaining the switching of columns targeted for readout.
[FIG. 24]

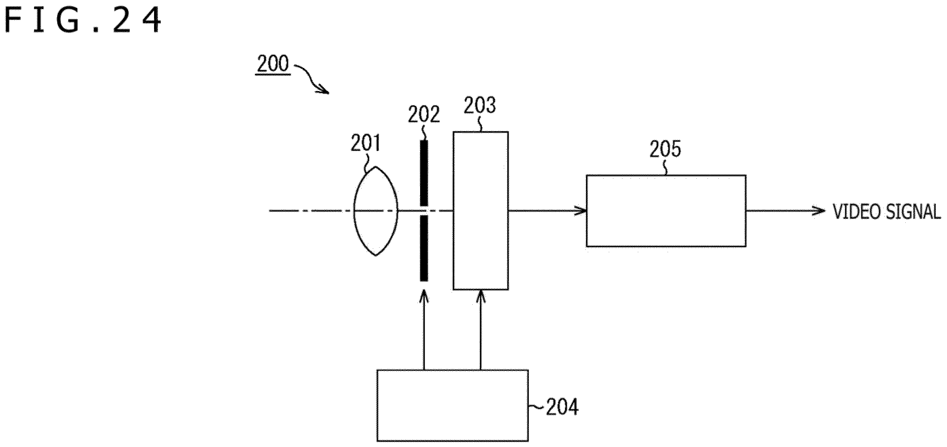

   FIG. 24 is a block diagram depicting an exemplary configuration of an electronic device according to the present disclosure.
[FIG. 25]

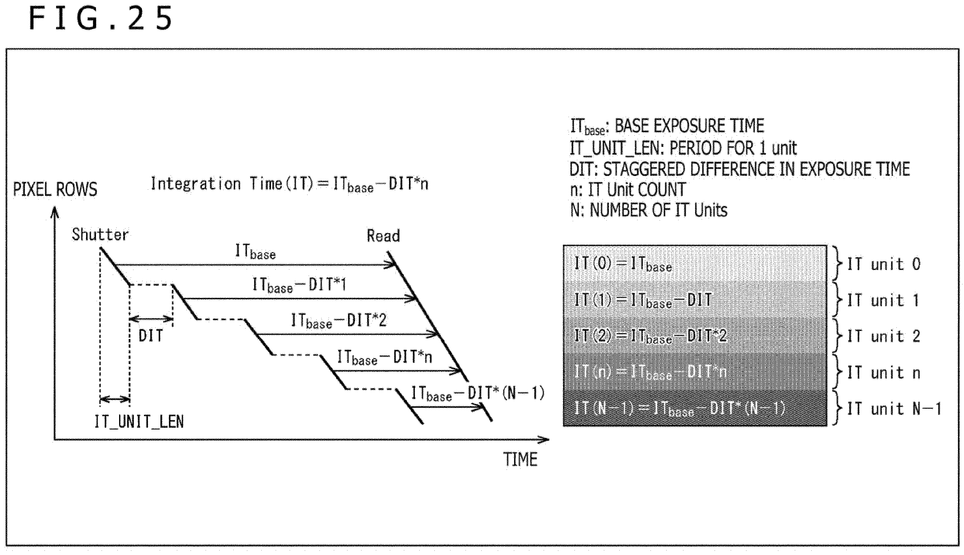

   FIG. 25 is a view explaining an overview of the technology according to the present disclosure.
[FIG. 26]

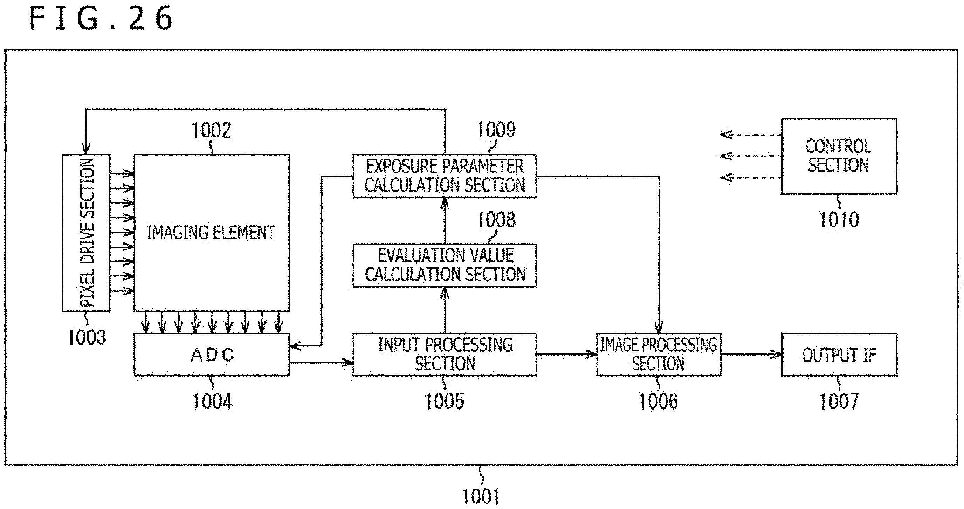

   FIG. 26 is a block diagram depicting an exemplary configuration of a solid-state imaging apparatus.
[FIG. 27]

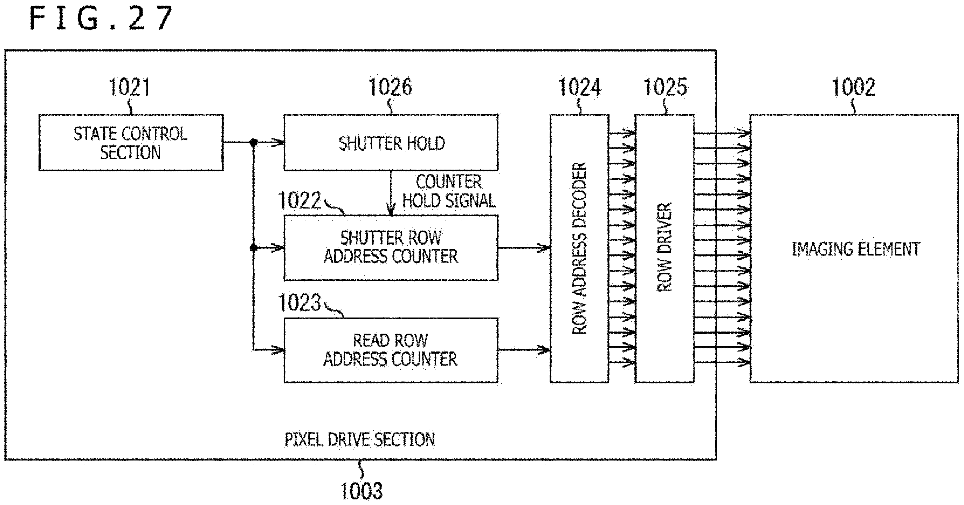

   FIG. 27 is a block diagram depicting an exemplary configuration of a pixel drive section.
[FIG. 28]

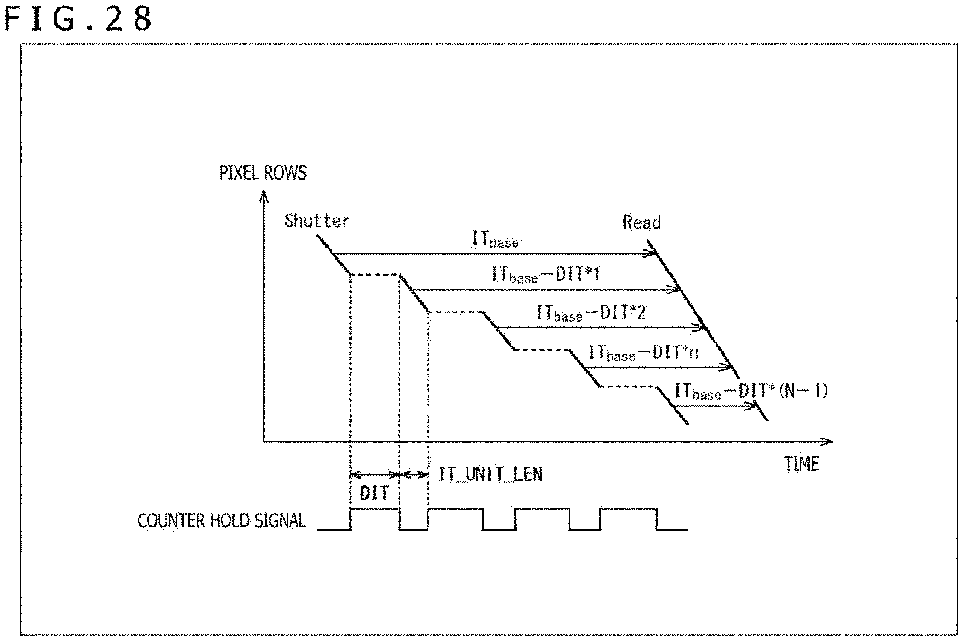

   FIG. 28 is a view explaining a counter hold signal.
[FIG. 29]

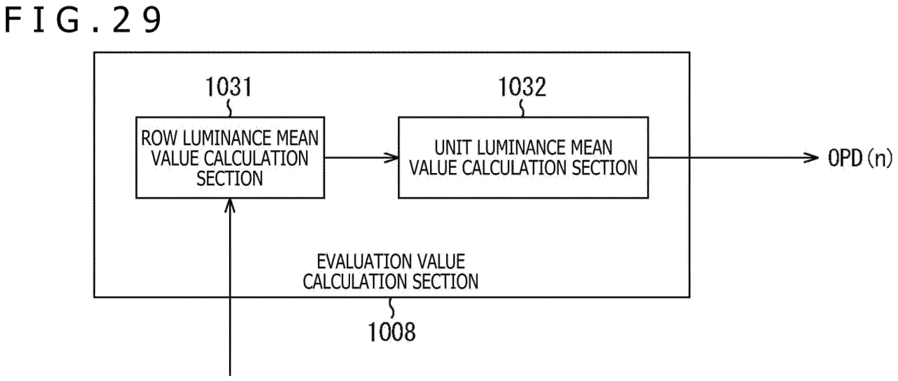

   FIG. 29 is a block diagram depicting an exemplary configuration of an evaluation value calculation section.
[FIG. 30]

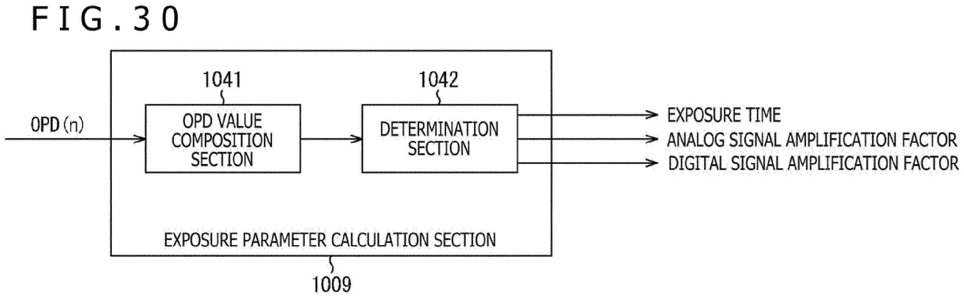

   FIG. 30 is a block diagram depicting a first exemplary configuration of an exposure parameter calculation section.
[FIG. 31]

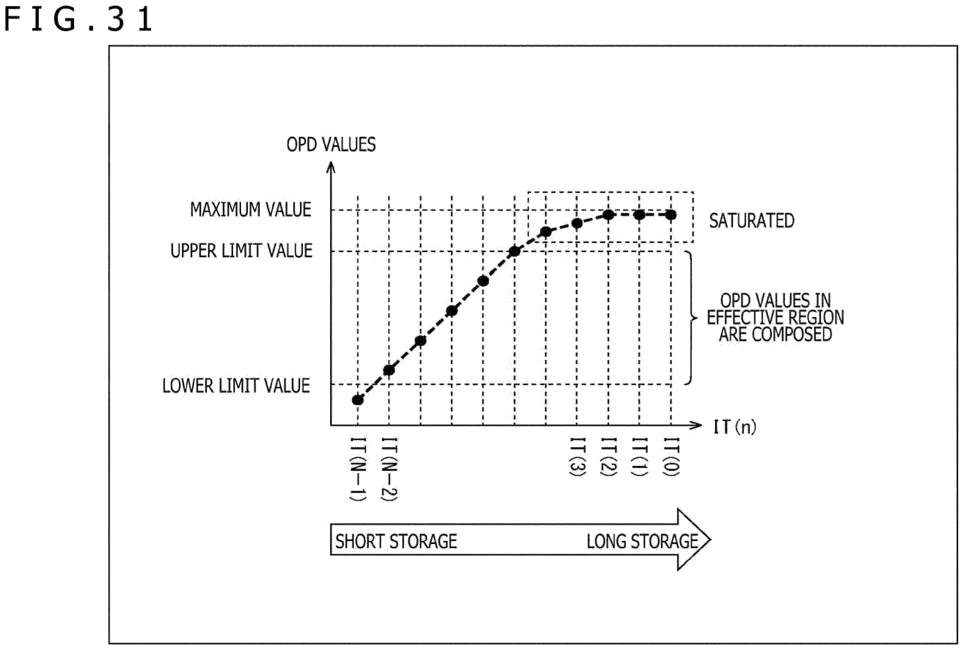

   FIG. 31 is a view explaining the composition of an OPD value.
[FIG. 32]

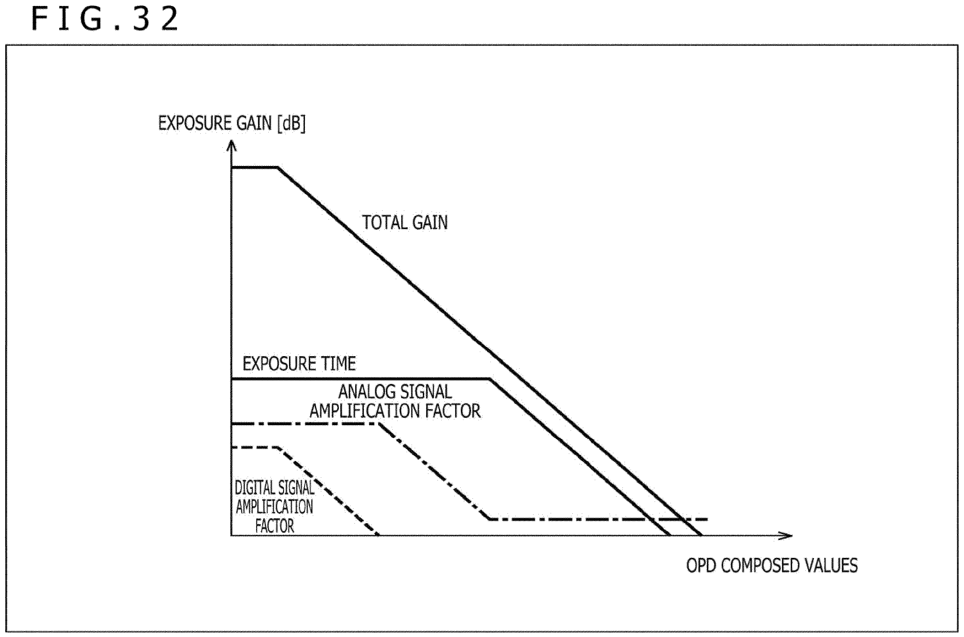

   FIG. 32 is a view explaining the determination of exposure parameters.
[FIG. 33]

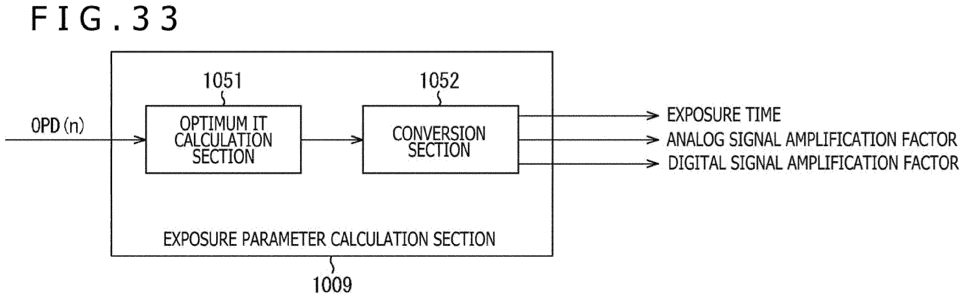

   FIG. 33 is a block diagram depicting a second exemplary configuration of the exposure parameter calculation section.
[FIG. 34]

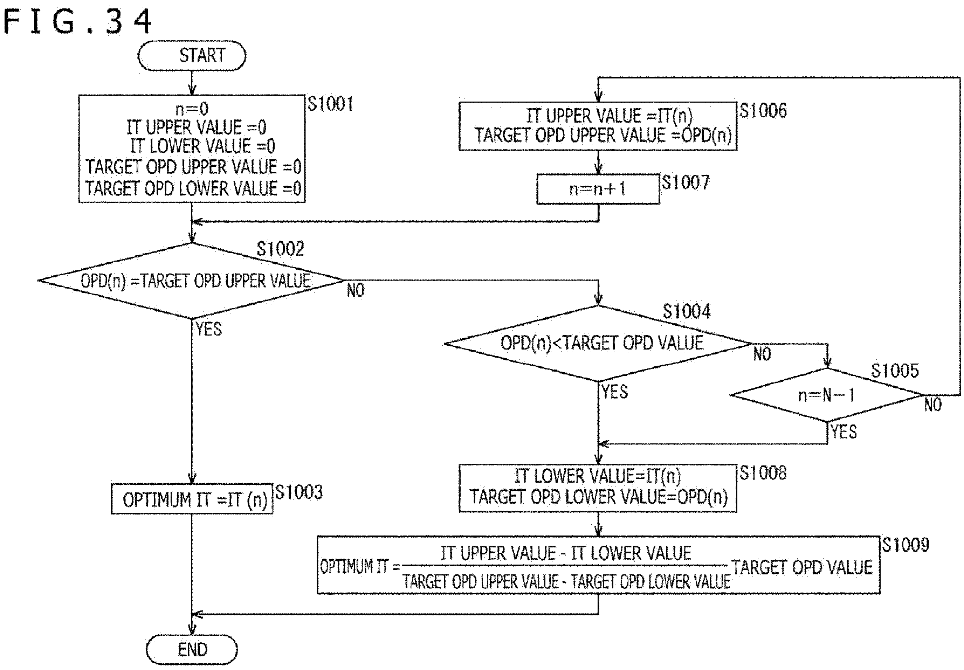

   FIG. 34 is a flowchart explaining an optimum IT calculation process.
[FIG. 35]

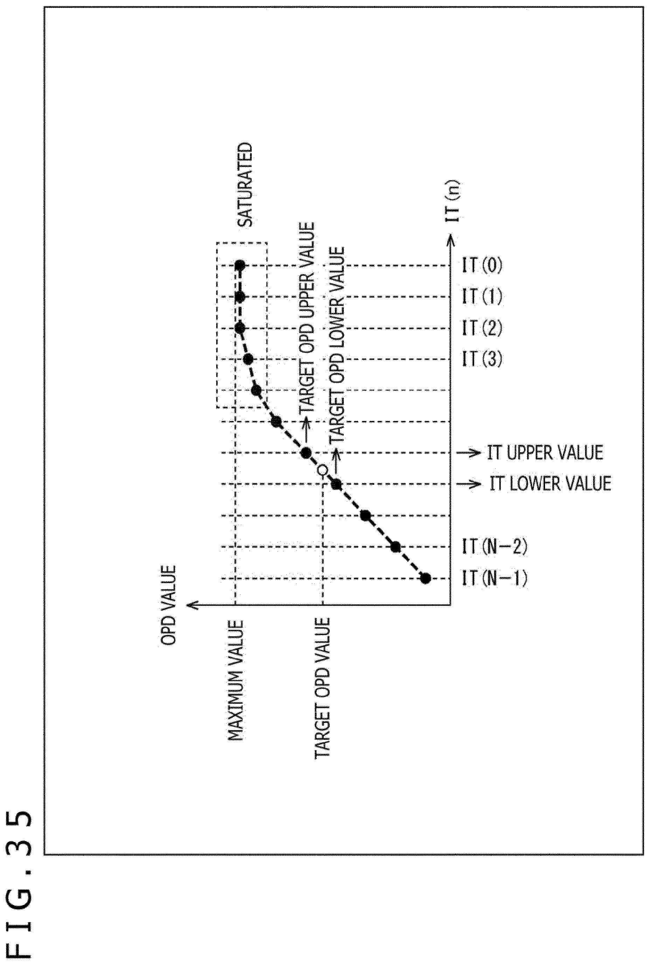

   FIG. 35 is a view explaining the calculation of an optimum IT.
[FIG. 36]

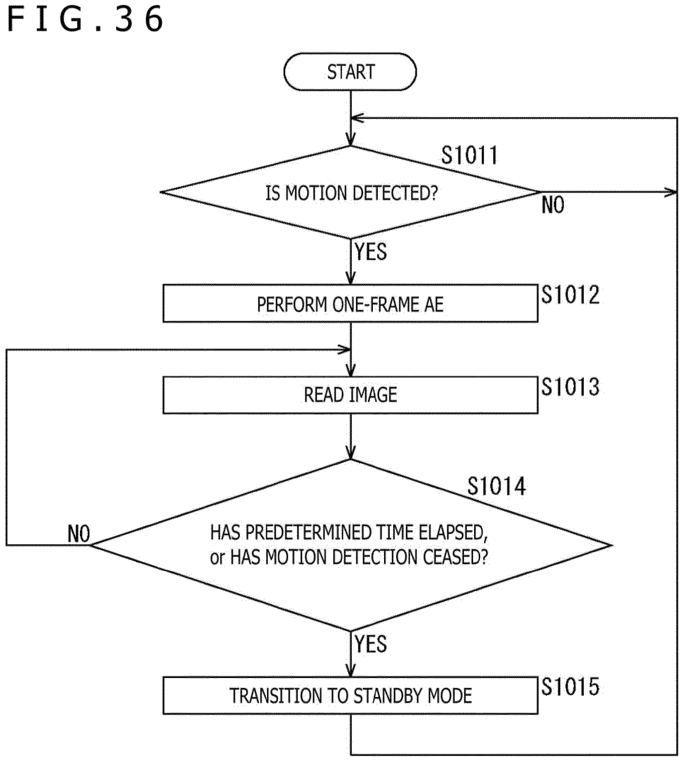

   FIG. 36 is a flowchart explaining operations in accordance with an imaging mode.
[FIG. 37]

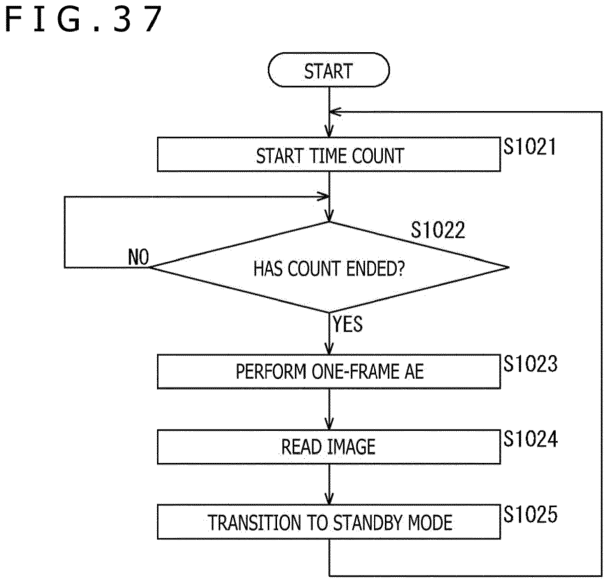

   FIG. 37 is a flowchart explaining other operations in accordance with the imaging mode.
[FIG. 38]

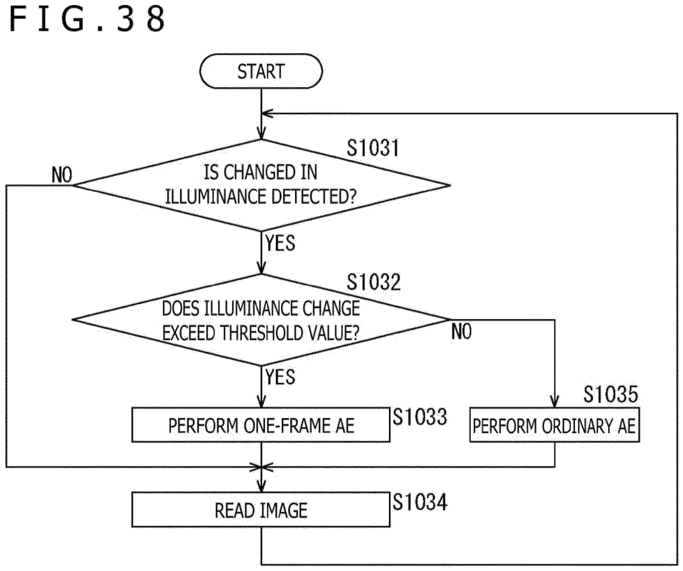

   FIG. 38 is a flowchart explaining other operations in accordance with the imaging mode.
[FIG. 39]

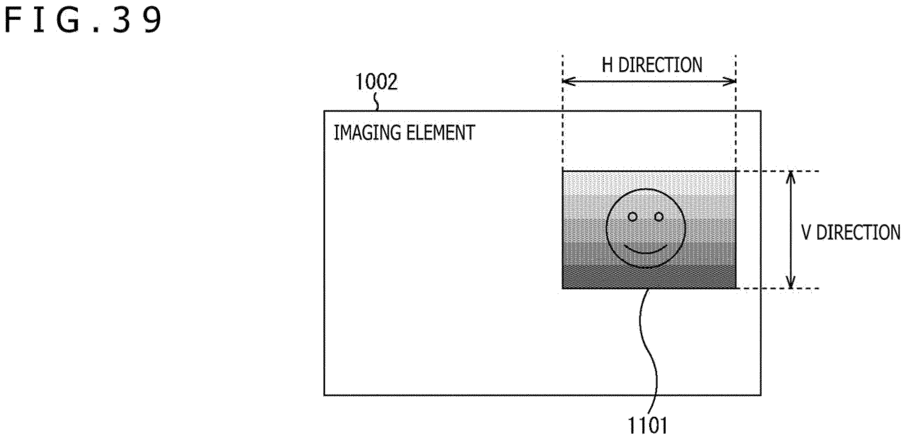

   FIG. 39 is a view explaining AE of a spot region.
[FIG. 40]

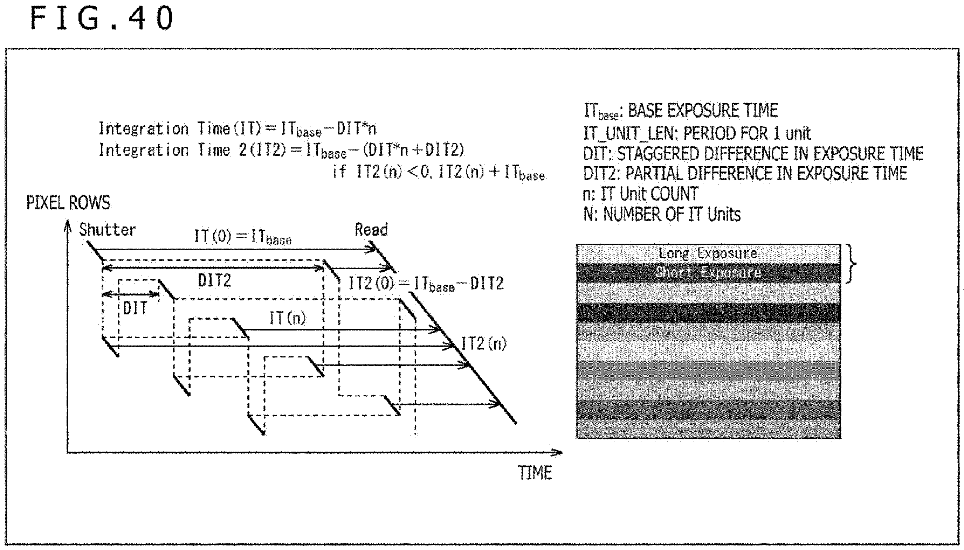

   FIG. 40 is a view explaining another example of one-frame AE.
[FIG. 41]

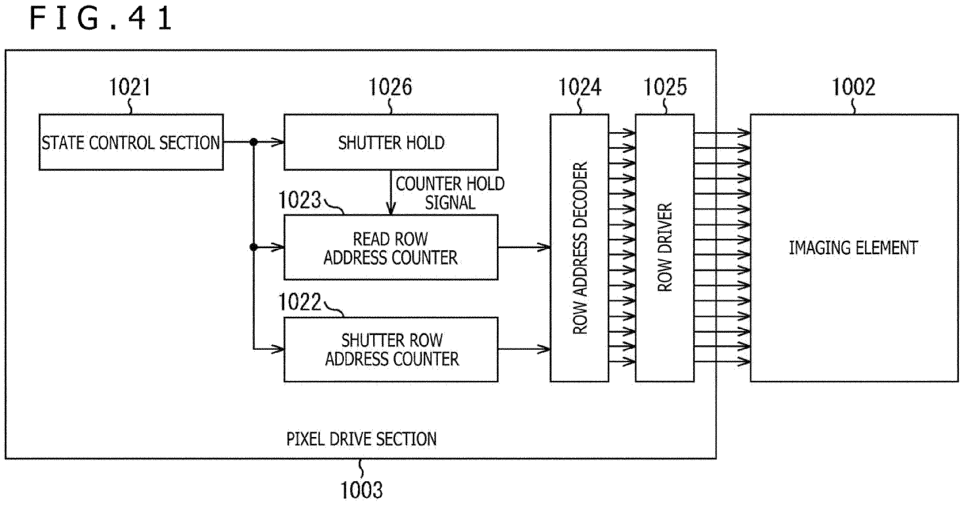

   FIG. 41 is a block diagram depicting another exemplary configuration of the pixel drive section.
[FIG. 42]

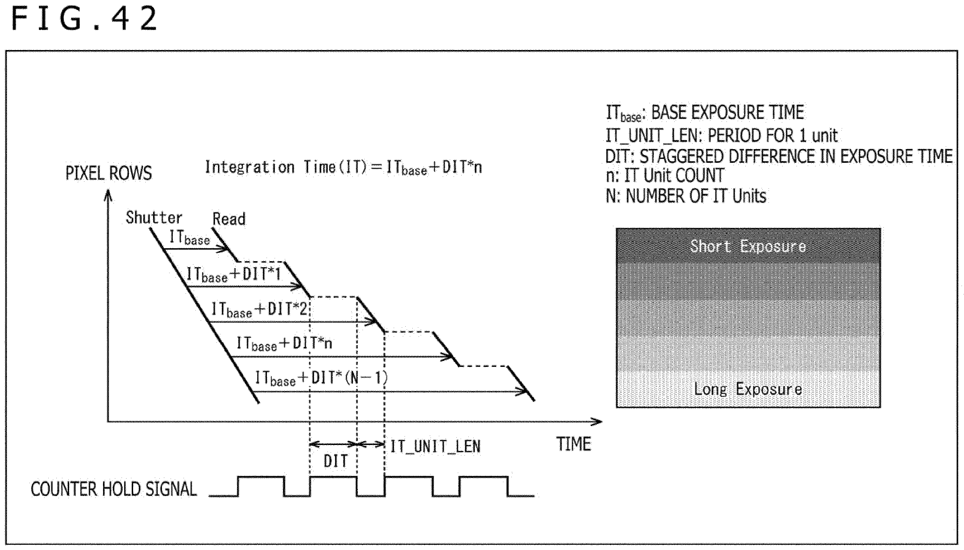

   FIG. 42 is a view explaining still another example of one-frame AE.
[FIG. 43]

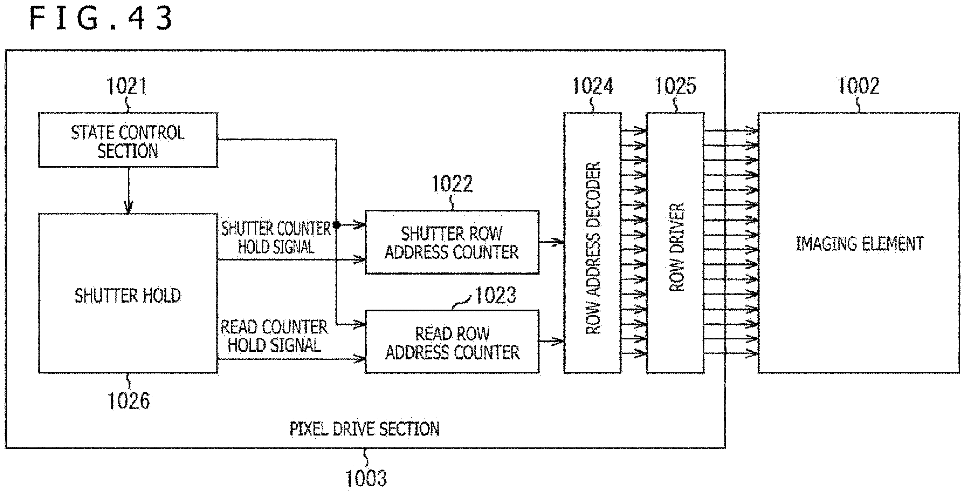

   FIG. 43 is a block diagram depicting still another exemplary configuration of the pixel drive section.
[FIG. 44]

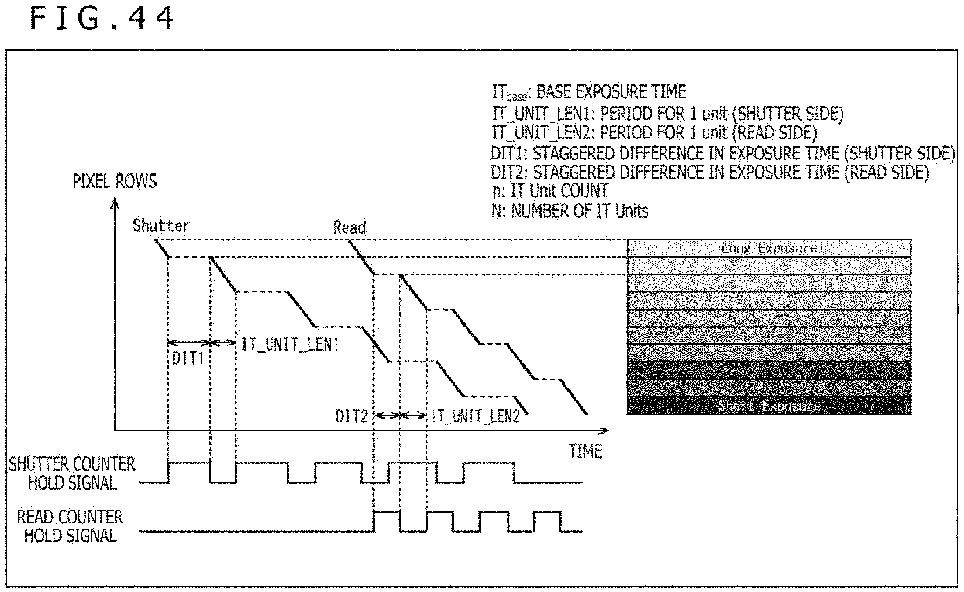

   FIG. 44 is a view explaining still another example of one-frame AE.
[FIG. 45]

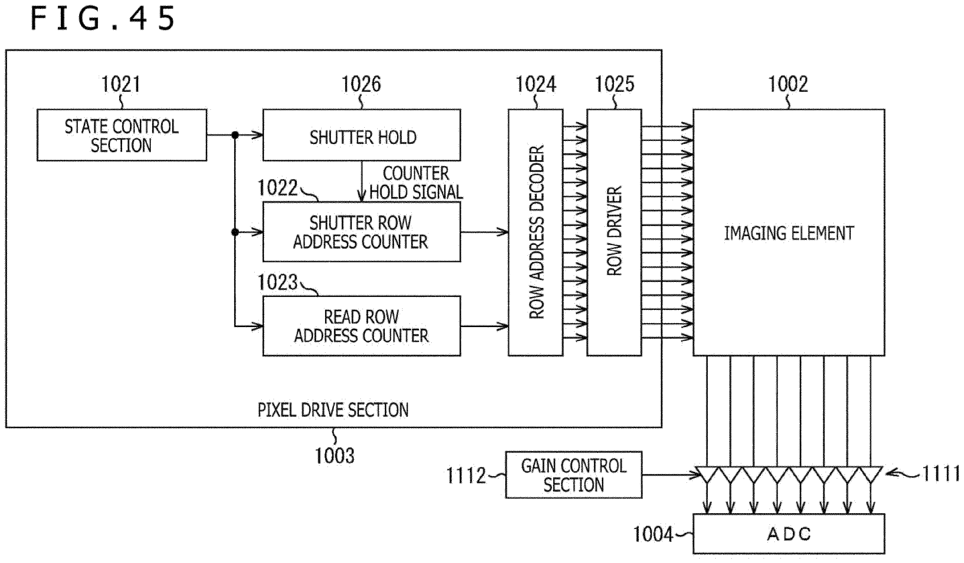

   FIG. 45 is a block diagram depicting still another exemplary configuration of the pixel drive section.
[FIG. 46]

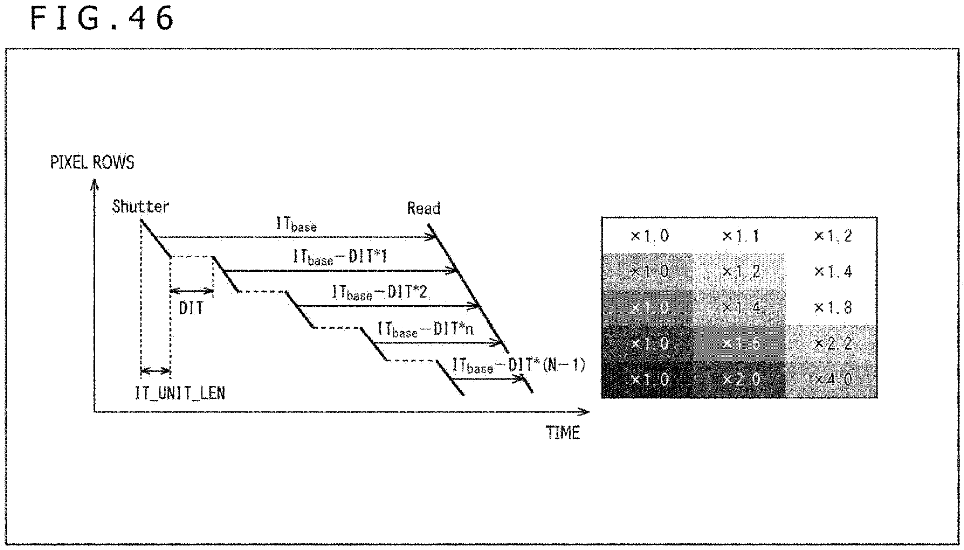

   FIG. 46 is a view explaining still another example of one-frame AE.
[FIG. 47]

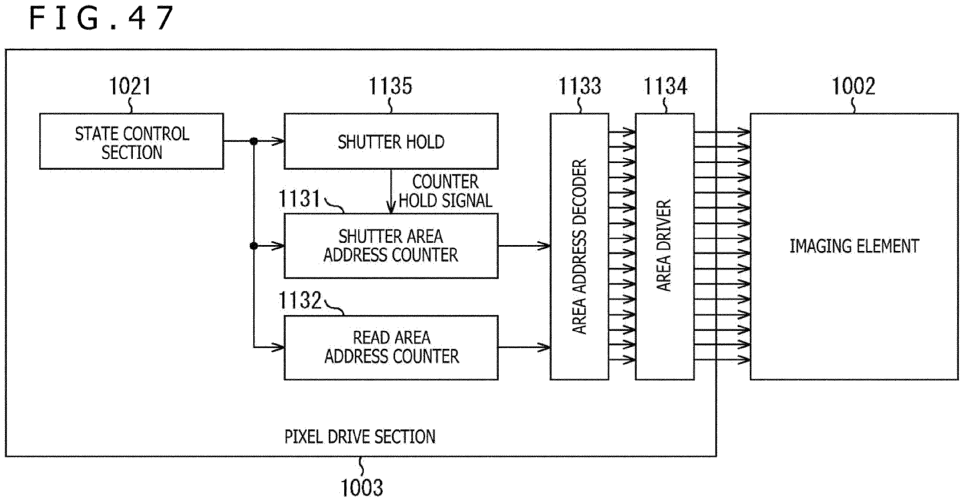

   FIG. 47 is a block diagram depicting still another exemplary configuration of the pixel drive section.
[FIG. 48]

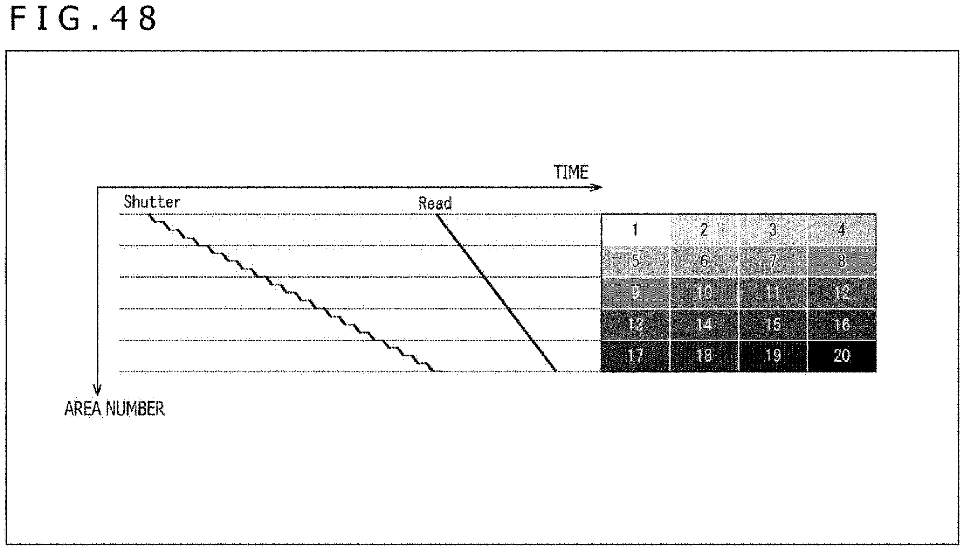

   FIG. 48 is a view explaining still another example of one-frame AE.
[FIG. 49]

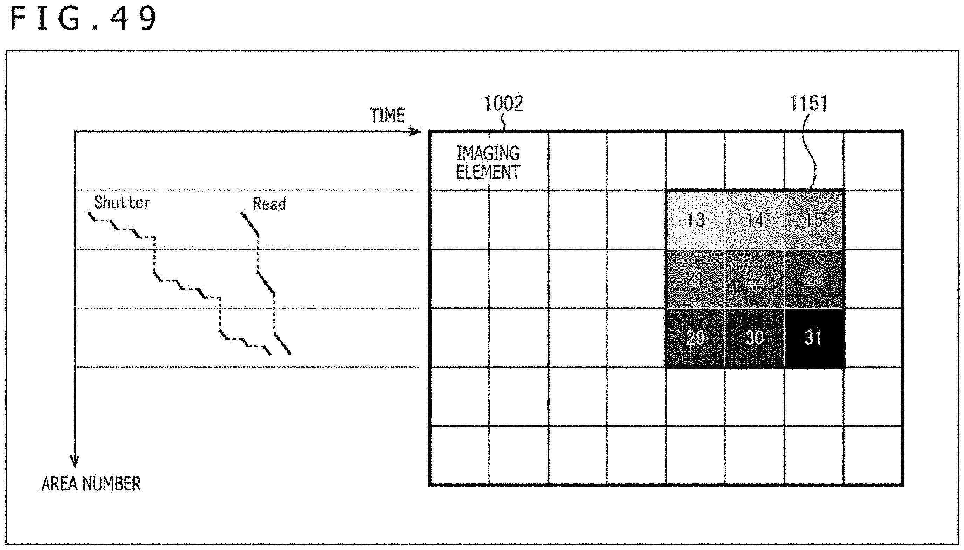

   FIG. 49 is a view explaining still another example of one-frame AE.
[FIG. 50]

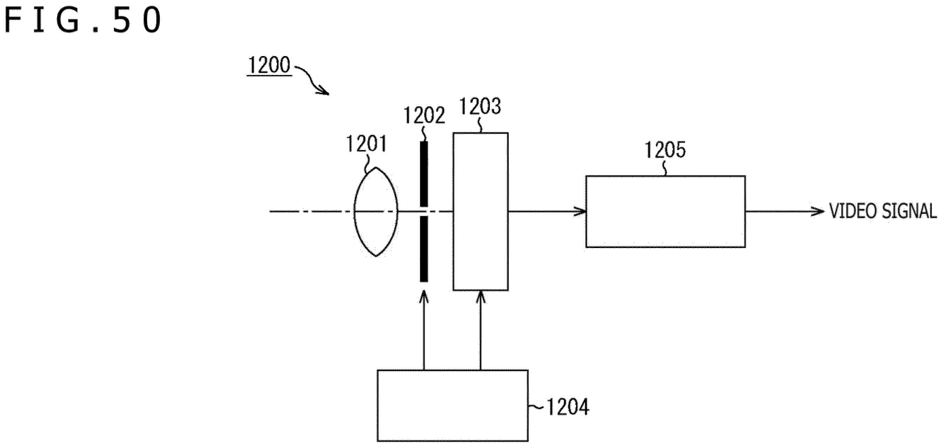

   FIG. 50 is a block diagram depicting an exemplary configuration of an electronic device.

Figures 3-4, 6, 21 and 22 are according to the invention.

Figures 1,2,5,7-20, 23-50 are not according to the invention and are present for illustration purposes only.

### [Description of Embodiments]

Preferred embodiments for implementing the present technology (referred to as the embodiments) are described below. The description will be given under the following headings:
1. First embodiment
1-1. Configuration of the solid-state imaging apparatus according to the present disclosure
1-2. Readout modes and column operations
1-3. Configuration and operations of the column enable control section
1-4. Method of controlling power to the column AD sections
1-5. Examples of use and alternative examples
1-6. Configuration of the electronic device according to the present disclosure
2. Second embodiment
2-1. Overview of the technology according to the present disclosure
2-2. Configuration of the solid-state imaging apparatus
2-3. Configuration of the pixel drive section
2-4. Configuration of the evaluation value calculation section
2-5. Configurations of the exposure parameter calculation section
2-6. Examples of use
2-7. Alternative examples
2-8. Configuration of the electronic device according to the present disclosure

### <1. First embodiment>

### <1-1. Configuration of the solid-state imaging apparatus according to the present disclosure>

### (Exemplary configuration of the solid-state imaging apparatus)

FIG. 1 is a block diagram depicting an exemplary configuration of a solid-state imaging apparatus according to the present disclosure.

A solid-state imaging apparatus 1 is configured as a CMOS (Complementary Metal Oxide Semiconductor) image sensor. The solid-state imaging apparatus 1 includes a pixel region (pixel array section) 3 and a peripheral circuit section, the pixel region 3 having multiple pixels 2 regularly arrayed two-dimensionally on a semiconductor substrate (e.g., Si substrate).

The pixel 2 has a photoelectric conversion section (e.g., photodiode) and multiple pixel transistors (MOS transistors). The multiple pixel transistors are constituted by three transistors, for example, a transfer transistor, a reset transistor, and an amplification transistor. Alternatively, the multiple transistors may be constituted by four transistors, i.e., the above-mentioned three transistors plus a selection transistor.

The pixel 2 can be configured either as a unit pixel or as a shared pixel structure. The shared pixel structure is a structure in which multiple photodiodes share floating diffusion and the transistors other than the transfer transistor.

The peripheral circuit section is configured with a pixel drive section 4, column AD sections 5, a column enable control section 6, an output circuit 7, and a control circuit 8.

The control circuit 8 is configured with a CPU (Central Processing unit), for example. Using predetermined programs and parameters, the control circuit 8 controls the pixel drive section 4, column AD sections 5, and column enable control section 6.

The pixel drive section 4 selects pixel drive lines and supplies pulses to the selected pixel drive lines to drive the pixels in units of rows. That is, the pixel drive section 4 selectively scans the pixels 2 in the pixel array section 3 in units of rows sequentially in a vertical direction. Then, the pixel drive section 4 supplies, via a vertical signal line 9, each column AD section 5 with a pixel signal on the basis of signal charges generated by the photoelectric conversion section of each pixel 2 in accordance with the amount of light received thereby.

The column AD sections 5 are each configured with a single-slope AD conversion circuit, for example. The column AD section 5 is provided for each of the columns of the pixels 2 in the pixel array section 3. The column AD section 5 performs signal processing such as noise removal on the signal output from one line of pixels 2 per column. Specifically, the column AD section 5 performs signal processing including CDS (Correlated Double Sampling) for removing fixed pattern noise specific to the pixels 2, signal amplification, and AD conversion. An output stage of the column AD section 5 has a horizontal selection switch (not depicted) connected with a horizontal signal line 10.

The column enable control section 6 controls the operations of the column AD sections 5. Specifically, under control of the control circuit 8, the column enable control section 6 provides programmable control of the operations of the column AD sections 5 in accordance with imaging mode. The pixel signal from each column AD section 5 is output onto the horizontal signal line 10.

The output circuit 7 performs signal processing on the signal supplied sequentially from each column AD section 5 via the horizontal signal line 10, before outputting the processed signal. The output circuit 7 may perform buffering only, or may carry out diverse digital signal processing operations including black level adjustment and column variation correction, for example.

### (Exemplary configuration of the column AD sections)

FIG. 2 is a block diagram block diagram depicting an exemplary configuration of the column AD sections 5.

The column AD sections 5 are each configured with a load MOS transistor 11, a comparator 12, a counter 13, and a latch circuit 14.

The load MOS transistor (LM) 11 is connected with the vertical signal line 9. The connection allows the amplification transistor of the pixel 2 and the load MOS transistor 11 to constitute a source follower circuit.

The comparator (CM) 12 compares a ramp signal input to one terminal and the pixel signal input to another terminal. The comparator 12 outputs to the counter 13 a signal of which the level is inverted depending on the magnitude relation between the ramp signal and the pixel signal.

The counter (CN) 13 performs an up-count operation and a down-count operation that are switched with each other. At the time the output of the comparator 12 is inverted, the counter 13 terminates the up-count operation and the down-count operation. The count value obtained from the up-count operation and the down-count operation is held in the latch circuit 14 before being output as digital data.

### <1-2. Readout modes and column operations>

In the solid-state imaging apparatus 1 of this embodiment, the column enable control section 6 operates only the column AD sections 5 of necessary columns and stops the operations of the column AD sections 5 of unnecessary columns in a readout mode corresponding to the imaging mode.

Exemplary column operations in different readout modes are explained below with reference to FIGS. 3 to 7.

### (ROI readout mode)

FIG. 3 is a view explaining column operations in ROI (region of interest) readout mode.

FIG. 3 depicts the pixel array section 3, column AD sections 5, and column enable control section 6.

In FIG. 3, the column AD sections 5 are each depicted as three rectangles representing a load MOS transistor, a comparator, and a counter arranged per column. In a case where the column AD sections 5 are indicated by gray rectangles, these column AD sections 5 are assumed to be operated. In a case where the column AD sections 5 are indicated by white rectangles, these column AD sections 5 are assumed to be stopped in operation. The same assumptions apply also to FIGS. 4 to 7.

In the example of FIG. 3, the pixels 2 are read from an ROI set in a partial region of the pixel array section 3 in the horizontal direction (H direction) and in a partial region thereof in the vertical direction (V direction).

In this case, the column enable control section 6 operates the column AD sections 5 of the columns corresponding to the H direction of the ROI, and stops the operations of the column AD sections 5 corresponding to the other columns. Note that the pixel rows corresponding to the V direction of the ROI are selectively driven by the pixel drive section 4.

In this manner, only the necessary columns are operated in accordance with the position of the set ROI while the operations of the unnecessary columns are stopped. This allows for saving on power consumption.

### (H direction interpolation readout mode)

FIG. 4 is a view explaining column operations in an H direction interpolation readout mode.

In the example of FIG. 4, the pixels 2 of the pixel array section 3 are interpolated in units of a predetermined number of columns in the H direction when read out.

In this case, the column enable control section 6 operates the column AD sections 5 in units of the columns in which the pixels are interpolated in the H direction of the pixel array section 3, and stops the operations of the column AD sections 5 of the other columns. In the example of FIG. 4, the column AD sections 5 are operated at intervals of three columns from the leftmost column of the pixel array section 3.

In this manner, only the necessary columns are operated in accordance with the set interpolation interval while the operations of the unnecessary columns are stopped. This allows for saving on power consumption.

The column operations in the H direction interpolation readout mode have been explained above. In an H direction thinning-out readout mode in which the pixels are thinned out when read in the H direction, the column operations are performed likewise in accordance with the set thinning-out interval.

### (H direction ROI readout plus H direction interpolation readout mode)

FIG. 5 is a view explaining column operations in a readout mode in which H direction ROI readout and H direction interpolation readout are performed.

In the example of FIG 5, the pixels 2 of the ROI set in a partial region in the H direction of the pixel array section 3 are interpolated in units of a predetermined number of columns in the H direction when read out.

In this case, the column enable control section 6 operates the column AD sections 5 in units of the columns in which the pixels are interpolated in the H direction of the ROI, and stops the operations of the column AD sections 5 of the other columns. In the example of FIG. 5, the column AD sections 5 are operated at intervals of three columns from the leftmost column of the ROI.

In this manner, only the necessary columns are operated in accordance with the position of the set ROI and the interpolation interval while the operations of the unnecessary columns are stopped. This allows for saving on power consumption.

### (H direction multiple ROI readout mode)

FIG. 6 is a view explaining column operations in an H direction multiple ROI readout mode.

In the example of FIG. 6, the pixels 2 of two ROIs set in partial regions in the H direction of the pixel array section 3 are read out.

In this case, the column enable control section 6 operates the column AD sections 5 of the columns corresponding to each of the two ROIs in the H direction, and stops the operations of the column AD sections 5 of the other columns.

In this manner, only the necessary columns are operated in accordance with the positions of the set multiple ROIs while the operations of the unnecessary column are stopped. This allows for saving on power consumption.

### (Column operations in accordance with read rows)

FIG. 7 is a view explaining column operations in accordance with read rows.

The left side in FIG. 7 depicts column operations at the time of reading an OPB region for black level adjustment. The right side in FIG. 7 illustrates column operations at the time of reading an ROI as an effective pixel region.

In the example of FIG. 7, the OPB region is set in a few top rows except for several columns at both ends in the H direction of the pixel array section 3. Further, the ROI is set in a partial region in the H direction and in a partial region in the V direction of the pixel array section 3.

At the time of reading the OPB region, the column enable control section 6 (not depicted) operates the column AD sections 5 of the columns corresponding to the OPB region in the H direction, and stops the operations of the column AD sections 5 of the other columns.

In contrast, at the time of reading the effective pixel region (ROI), the column enable control section 6 (not depicted) operates the column AD sections 5 of the columns corresponding to the ROI in the H direction, and stops the operations of the column AD sections 5 of the other columns.

In general, a mean value of the pixel values in the OPB region is used for black level adjustment. However, in a case where the sampled number of the pixels to be read from within the OPB region is small, the accuracy of black level adjustment is reduced. That is, in a case where only the column AD sections 5 of the columns corresponding to the ROI are operated at the time of black level adjustment, there is fear that the accuracy of black level adjustment will be lowered.

In that case, as in the example of FIG. 7, the column AD sections 5 of the columns corresponding to the OPB region that is wider in the H direction than the ROI are operated. This enables suppression of reduction in the accuracy of black level adjustment.

In this manner, the range of the columns to be operated may be controlled dynamically in accordance with the read rows. This allows for saving on power consumption efficiently.

As described above, the solid-state imaging apparatus 1 of this embodiment makes it possible to save on power consumption without recourse to readout modes.

### <1-3. Configuration and operations of the column enable control section>

The configuration and operations of the column enable control section implementing the above-described column operation control are explained below.

### (Configuration of the column enable control section)

FIG. 8 is a view depicting an exemplary configuration of the column enable control section 6.

The column enable control section 6 controls the output of operation signals (column enable signals) for operating the column AD sections 5 under control of the CPU 30 running on specific firmware.

The column enable control section 6 includes a controller 31 and registers 32.

The controller 31 controls the operations of the registers 32 under control of the CPU 30. The registers 32 include those for outputting the column enable signals to the column AD sections 5 of the columns.

In the example of FIG. 8, the total number of columns is assumed to be N. The column enable signals column0 enable, column1 enable, column2 enable, ..., columnN-1 enable (= COLEN[0], COLEN[1], COLEN[2], ..., COLEN[N-1]) are output to the column AD sections 5 of the columns.

Specifically, the controller 31 outputs to the registers 32 a setting signal for setting the columns to be operated on the basis of parameters supplied from the CPU 30. In accordance with the setting signal from the controller 31, those of the registers 32 that output the column enable signals are determined.

The parameters supplied from the CPU 30 are set in accordance with imaging mode (readout mode). The parameters permit programmable control of the operations of the column AD sections 5 in accordance with imaging mode.

What follows is a specific description of exemplary implementations of the column enable control section 6.

### (First exemplary implementation of the column enable control section)

FIG. 9 is a block diagram depicting a first exemplary implementation of the column enable control section 6. The column enable control section 6 in FIG. 9 also controls the output of the column enable signals for operating the column AD sections 5 under control of a CPU 40 to which specific firmware has been written.

The column enable control section 6 includes a shift controller 41, shift registers 42, and a clock controller 43.

On the basis of a parameter supplied from the CPU 40, the shift controller 41 outputs to the shift registers 42 a setting signal CLM_SET for setting the columns to be operated.

The parameter supplied from the CPU 40 include, for example, COL_START, COL_END, COL_SKIP, COL_OFF#, and COL_OFFWID#.

The parameters COL_START and COL_END denote, respectively, the column number of the column at one end (start) and the column number of the column at the other end (end) of the consecutive columns targeted for readout.

The parameter COL_SKIP represents the number of the consecutive columns not targeted for readout (columns to be skipped) from among the individual columns targeted for periodical readout. In other words, COL_SKIP stands for the number of the columns to be thinned out in the H direction thinning-out readout mode.

The parameters COL_OFF# and COL_OFFWID# denote, respectively, the column number of the column at one end of the consecutive columns not targeted partially for readout, and the number of the consecutive columns starting from that column.

Also, on the basis of a reset signal COLEN_RESET supplied from the CPU 40, the shift controller 41 outputs to the shift registers 42 a setting signal CONFIG_DONE representing the period during which the shift registers 42 are caused to set contents of the setting signal CLM_SET (whether or not to operate the column).

Further, on the basis of the reset signal COLEN_RESET supplied from the CPU 40, the shift controller 41 outputs to the clock controller 43 an operation signal SHIFT_CLK_EN for causing the clock controller 43 to output a clock signal.

In accordance with the operation signal SHIFT_CLK_EN from the shift controller 41, the clock controller 43 outputs a clock signal SHIFT_CLK to the shift registers 42.

During the period represented by the setting signal CONFIG_DONE, the shift registers 42 set the contents of the setting signal CLM_SET to each of the columns in accordance with the clock signal SHIFT_CLK. At the end of the period represented by the setting signal CONFIG_DONE, the shift registers 42 output the column enable signals COLEN each reflecting the contents of the setting signal CLM_SET set to each of the columns.

Specifically, the shift registers 42 include flip-flops corresponding to the columns 0 to N-1. The output of each flip-flop is input to one input terminal of an AND gate provided for each column. The setting signal CONFIG_DONE is input to the other input terminal of the AND gate. The output terminal of the AND gate outputs a column enable signal COLEN. That is, when the output of the flip-flop and the setting signal CONFIG_DONE both go "H" (High), the column enable signal COLEN is output to each column.

### (Operations of the column enable control section)

The operations of the column enable control section 6 in FIG. 9 are described below with reference to the timing charts in FIGS. 10 to 12. Note that, tn the following description, the total number of columns is also assumed to be N.

FIG. 10 is a timing chart depicting the operations of the column enable control section 6 in an H direction ROI readout mode.

First, when the reset signal COLEN_RESET from the CPU 40 is "H," the shift controller 41 causes the operation signal SHIFT_CLK_EN to go "H." With the operation signal SHIFT_CLK_EN going "H," the clock controller 43 starts outputting the clock signal SHIFT_CLK to the shift registers 42. The period in which the operation signal SHIFT_CLK_EN is "H" lasts N clock cycles of the clock signal SHIFT_CLK.

At the time the reset signal COLEN_RESET from the CPU 40 goes from "H" to "L" (Low), the shift controller 41 causes the setting signal CONFIG_DONE to go from "H" to "L." The period in which the setting signal CONFIG_DONE is "L" lasts N clock cycles of the clock signal SHIFT_CLK.

During the period in which the setting signal CONFIG_DONE is "L" (in N clock cycles), the shift registers 42 set the contents of the setting signal CLM_SET to each of the columns in accordance with the clock signal SHIFT_CLK. Specifically, the shift registers 42 hold "H" the output of each of the flip-flops corresponding to the columns targeted for readout.

In the example of FIG. 10, the setting signal CLM_SET is "L" during a clock period of N-COL_END-1 after the setting signal CONFIG_DONE goes "L." Thereafter, the setting signal CLM_SET is "H" during a clock period of COL_END-COL_START+1. Then, the setting signal CLM_SET is "L" during the remaining COL_START clock period until the setting signal CONFIG_DONE goes "H."

In this manner, the shift registers 42 hold "H" the output of each of the flip-flops corresponding to the columns ranging from the COL_START column to the COL_END column.

When the setting signal CONFIG_DONE goes from "L" to "H," the shift registers 42 cause the column enable signals COLEN to be output from the AND gates corresponding to the columns ranging from COL_START column to the COL_END column.

In the above operations, the columns ranging from the COL_START column to the COL_END column can be read from the ROI in the H direction.

In the above operations, the clock controller 43 operates only during the period in which the setting signal CONFIG_DONE is "L." This enables suppression of power consumption of the column enable control section 6.

Further, the range (position) of the ROI can be set with a high degree of freedom solely by use of the settings of the parameters COL_START and COL_END.

FIG. 11 is a timing chart depicting the operations of the column enable control section 6 in an H direction ROI readout plus H direction interpolation (thinning-out) readout mode.

In FIG. 11, the signals other than the setting signal CLM_SET are the same as in the example of FIG. 10.

In the example of FIG. 11, the setting signal CLM_SET is "L" during the clock period of N-COL_END-1 after the setting signal CONFIG_DONE goes "L." Thereafter, the setting signal CLM_SET goes "H" during one clock period at intervals of a COL_SKIP clock period. Then, the setting signal CLM_SET is "L" during the remaining COL_START clock period until the setting signal CONFIG_DONE goes "H."

In this manner, the shift registers 42 hold "H" the output of the flip-flops corresponding to the columns at intervals of COL_SKIP columns from among the columns ranging from the COL_START column to the COL_END column.

When the setting signal CONFIG_DONE goes from "L" to "H," the shift registers 42 cause the column enable signals COLEN to be output from the AND gates corresponding to the columns at intervals of COL_SKIP columns from the COL_START column to the COL_END column.

In the above operations, the ROI in the H direction ranging from the COL_START column to the COL_END column can be interpolated (thinned out) at intervals of COL_SKIP+1 columns when read out.

In the above operations, the clock controller 43 operates only during the period in which the setting signal CONFIG_DONE is "L." This enables suppression of power consumption of the column enable control section 6.

Further, the position of the ROI and the interpolation (thinning-out) interval can be set flexibly with a high degree of freedom solely by use of the settings of the parameters COL_START, COL_END, and COL_SKIP.

FIG. 12 is a timing chart depicting the operations of the column enable control section 6 in the H direction multiple ROI readout mode.

Also in FIG. 12, the signals other than the setting signal CLM_SET are also the same as in the example of FIG. 10.

In the example of FIG. 12, the setting signal CLM_SET is "L" during the clock period of N-COL_END-1 after the setting signal CONFIG_DONE goes "L." Thereafter, the setting signal CLM_SET is "H" during the period of COL_END-COL_START+1. Then, the setting signal CLM_SET is "L" during the remaining COL_START clock period until the setting signal CONFIG_DONE goes "H."

It is to be noted, however, that the setting signal CLM_SET is "L" only during a clock period of COL_OFFWID1 earlier than the timing of the setting signal CONFIG_DONE going "H" by a clock period of COL_OFF1 and during a clock period of COL_OFFWID2 earlier than the timing of the setting signal CONFIG_DONE going "H" by a clock period of COL_OFF2.

In this manner, the shift registers 42 hold "H" the output of the flip-flops corresponding to the columns ranging from the COL_START column to the COL_END column except for those columns ranging from a column COL_OFF1 to a column COL_OFFWID1 not targeted for readout and for those ranging from a column COL_OFF2 to a column COL_OFFWID2 not targeted for readout.

When the setting signal CONFIG_DONE goes from "L" to "H," the shift registers 42 cause the column enable signals COLEN to be output from the AND gates corresponding to the columns ranging from the COL_START column to the COL_END column except for those columns not targeted for readout.

In the above operations, H direction multiple ROI readout is carried out.

In the above operations, the clock controller 43 operates only during the period in which the setting signal CONFIG_DONE is "L." This enables suppression of power consumption of the column enable control section 6.

Further, the range of the columns not targeted for readout can be set with a high degree of freedom solely by use of the settings of the parameters COL_OFF# and COL_OFFWID#.

### (Second exemplary implementation of the column enable control section)

FIG. 13 is a block diagram depicting a second exemplary implementation of the column enable control section 6. The column enable control section 6 in FIG. 13 also controls the output of the column enable signals for operating the column AD sections 5 under control of a CPU 50 to which specific firmware has been written.

The column enable control section 6 includes a skip decoder 51 and comparators 52 each provided for each of the columns.

The skip decoder 51 outputs a setting signal PHASE_EN[m] for setting the columns to be skipped in a cycle of a column count of M (phase count M) in reference to the column represented by the parameter COL_START on the basis of the parameters COL_START and COL_SKIP supplied from the CPU 50. A reference character m ranges from 0 to M-1.

Specifically, in a case where (COL_START+m)%(COL_SKIP+1) = 0, the setting signal PHASE_EN[m] is "H." Here, the sign % represents a remainder operation.

On the basis of the parameters COL_START and COL_END supplied from the CPU 50, the comparators 52 output a column enable flag AREA_EN[n] indicating whether or not each of the columns is targeted for readout. When the total number of columns is assumed to be N, the number n ranges from 0 to N-1.

Specifically, when the relations of COL_START ≤ n and COL_END ≥ n are satisfied, the column enable flag AREA_EN[n] is "H."

The column enable control section 6 in FIG. 13 includes an AND gate for each of the columns, the AND gate outputting the column enable signal COLEN to the corresponding column. The column enable flag AREA_EN[n] is input to one input terminal of the AND gate for the column n. A setting signal PHASE_EN[n%m] is input to the other input terminal of the AND gate. That is, the column enable signal COLEN is output to each column when the column enable flag AREA_EN[n] and the setting signal PHASE_EN[n%m] both go "H."

### (Operations of the column enable control section)

Described below with reference to FIGS. 14 to 16 are the operations of the column enable control section 6 in FIG. 13. In the following description, the number of columns N is assumed to be 22.

FIG. 14 is a view explaining the operations of the column enable control section 6 in the H direction ROI readout mode.

In the example of FIG. 14, the parameter COL_START is set to 4 and the parameter COL_END is set to 18. Given the settings, the column enable flags AREA_EN[4] ..., AREA_EN[18] go "H" for columns 4 through 18.

Also in the example of FIG. 14, the parameter COL_SKIP is set to 0, and a setting signal PHASE_EN[7:0] is expressed in binary notation as 1111_1111. That is, the setting signals PHASE_EN[m] go "H" for all columns in a cycle of 8 columns, so that none of the columns is skipped.

In the above operations, the ROI in the H direction can be set ranging from column 4 to column 18 by use of the settings of the parameters COL_START, COL_END, and COL_SKIP.

FIG. 15 is a view explaining the operations of the column enable control section 6 in the H direction ROI readout plus H direction interpolation (thinning-out) readout mode.

In the example of FIG. 15, the parameter COL_START is set to 4 and the parameter COL_END is set to 18. Given the settings, the column enable flags AREA_EN[4] ..., AREA_EN[18] go "H" for columns 4 through 18.

Also in the example of FIG. 15, the parameter COL_SKIP is set to 3, and the setting signal PHASE_EN[7:0] is expressed in binary notation as 0001_0001. Specifically, (COL_START+m)%(COL_SKIP+1) is expressed as 1, 0, 0, 0, 1, 0, 0, 0 for the reference character m being 0 through 7, respectively. That is, in a cycle of eight columns, the setting signal PHASE_EN[m] is "H" for columns 1 and 5, so that columns 2 through 4 and columns 6 through 8 are skipped.

In the above operations, the settings of the parameters COL_START, COL_END, and COL_SKIP allow the ROI in the H direction ranging from column 4 to column 18 to be interpolated (thinned out) starting from column 4 at intervals of three columns when read out.

FIG. 16 is a view explaining the operations of the column enable control section 6 in the H direction ROI readout plus H direction interpolation (thinning-out) readout mode.

In the example of FIG. 16, the parameter COL_START is set to 6 and the parameter COL_END is set to 16. Given the settings, the column enable flags AREA_EN[6] ..., AREA_EN[16] go "H" for columns 6 through 16.

Also, in the example of FIG. 16, the parameter COL_SKIP is set to 3, and the setting signal PHASE_EN[7:0] is expressed in binary notation as 0100_0100. Specifically, (COL_START+m)% (COL_SKIP+1) is expressed as 0, 0, 1, 0, 0, 0, 1, 0 for the reference character m being 0 through 7, respectively. That is, in a cycle of eight columns, the setting signal PHASE_EN[m] is "H" for columns 3 and 7, so that columns 1, 2, 4 through 6, and 8 are skipped.

In the above operations, the settings of the parameters COL_START, COL_END, and COL_SKIP allow the ROI in the H direction ranging from column 6 to column 16 to be interpolated (thinned out) starting from column 6 at intervals of three columns when read out.

### (Third exemplary implementation of the column enable control section)

FIG. 17 is a block diagram depicting a third exemplary implementation of the column enable control section 6. The column enable control section 6 in FIG. 17 also controls the output of the column enable signals for operating the column AD sections 5 under control of a CPU 60 to which specific firmware has been written.

The column enable control section 6 includes a skip decoder 61 and comparators 62 each provided for each of the columns.

The skip decoder 61, as with the skip decoder 51 in FIG. 13, outputs PHASE_EN[m] on the basis of the parameters COL_START and COL_SKIP supplied from the CPU 60.

On the basis of the parameters COL_START, COL_END, COL_START1, COL_END1, COL_START2, and COL_END2 supplied from the CPU 60, the comparators 62 output a column enable flag AREA_EN[n] indicating whether or not each of the columns is targeted for readout.

Specifically, when the relations of COL_START ≤ n and COL_END ≥ n, the relations of COL_START1 ≤ n and COL_END1 ≥ n, or the relations of COL_START2 ≤ n and COL_END2 ≥ n are satisfied, the column enable flag AREA_EN[n] goes "H."

The parameters COL_START1 and COL_END1 represent the column number of the first column and that of the end column of the ROI in the H direction set next to (on the right of) the ROI in the H direction identified by the parameters COL_START and COL_END. The parameters COL_START2 and COL_END2 denote the column number of the first column and that of the end column of the ROI in the H direction set next to (on the right of) the ROI in the H direction identified by the parameters COL_START1 and COL_END1.

The column enable control section 6 in FIG. 17 also has an AND gate arranged for each of the columns, the AND gate outputting the column enable signal COLEN to each column. The column enable flag AREA_EN[n] is input to one input terminal of the AND gate for the column n. The setting signal PHASE EN[n%m] is input to the other input terminal of the AND gate. That is, the column enable signal COLEN is output to each of the columns when the column enable flag AREA EN[n] and the setting signal PHASE JEN[n%m] are both "H."

### (Operations of the column enable control section)

Described below with reference to FIGS. 18 and 19 are the operations of the column enable control section 6 in FIG. 17. In the following description, the number of columns N is also assumed to be 22.

FIG. 18 is a view explaining the operations of the column enable control section 6 in the H direction multiple ROI readout mode.

In the example of FIG. 18, the parameter COL_START is set to 2, COL_END to 6, COL_START1 to 9, COL_END1 to 13, COL_START2 to 16, and COL_END2 to 20. Given these settings, the column enable flags AREA_EN[2], ..., AREA_EN[6] for columns 2 to 6, AREA_EN[9], ..., AREA_EN[13] for columns 9 to 13, and AREA_EN[16], ..., AREA_EN[20] for columns 16 to 20 go "H."

Also, in the example of FIG. 18, the parameter COL_SKIP is set to 0, and the setting signal PHASE_EN[7:0] is expressed in binary notation as 1111_1111. That is, the setting signal PHASE_EN[m] is "H" for all columns in a cycle of eight columns, so that none of the columns is skipped.

In the above operations, three ROIs in the H direction, i.e., ROI from column 2 to column 6, ROI from column 9 to column 13, and ROI from column 16 to column 20 in the H direction, can be set by use of the settings of the parameters COL_START, COL_END, COL_SKIP, COL_START1, COL_END1, COL_START2, and COL_END2.

FIG. 19 is a view explaining the operations of the column enable control section 6 in H direction multiple ROI readout plus H direction interpolation (thinning-out) readout mode.

Also in the example of FIG. 19, as in the example of FIG. 18, the parameter COL_START is set to 2, COL_END to 6, COL_START1 to 9, COL_END1 to 13, COL_START2 to 16, and COL_END2 to 20. Given these settings, the column enable flags AREA_EN[2], ..., AREA_EN[6] are "H" for columns 2 to 6, AREA_EN[9], ..., AREA_EN[13] are "H" for columns 9 to 13, and AREA_EN[16], ..., AREA_EN[20] are "H" for columns 16 to 20.

Also, in the example of FIG. 19, the parameter COL_SKIP is set to 1, and the setting signal PHASE_EN[7:0] is expressed in binary notation as 0001_0001. Specifically, (COL_START+m)%(COL_SKIP+1) is expressed as 1, 0, 1, 0, 1, 0, 1, 0 for the reference character m being 0 through 7, respectively. That is, in a cycle of eight columns, the setting signal PHASE_EN[m] is "H" for columns 1, 3, 5, and 7, so that columns 2, 4, 6, and 8 are skipped.

In the above operations, the settings of the parameters COL_START, COL_END, COL_SKIP, COL_START1, COL_END1, COL_START2, and COL_END2 allow three ROIs in the H direction, i.e. ROI from column 2 to column 6, ROI from column 9 to column 13, and ROI from column 16 to column 20 in the H direction, to be interpolated (thinned out) at intervals of one column starting from column 2 when read out.

### <1-4. Method of controlling power to the column AD sections>

Explained below with reference to FIG. 20 is the method of controlling power to the column AD sections 5 by use of the column enable signal COLEN.

FIG. 20 depicts a load MOS transistor (LM) 11, a comparator (CM) 12, and a counter (CN) 13 for each column.

The LM 11 is connected with the output terminal of a NOR gate 71. The column enable signal COLEN is input to one input terminal of the NOR gate 71. An all-LM forced-ON signal for forcibly turning ON all LMs 11 is input to the other input terminal. When the output of the NOR gate 71 is "H," the current on the vertical signal line 9 (VSL) to the LMs 11 is cut off, so that the LMs 11 are turned OFF.

In a case where the all-LM forced-ON signal is "H," the output of the NOR gate 71 is "L" regardless of the column enable signal COLEN, so that the current on the VSL is not cut off. That is, in a case where the all-LM forced-ON signal is "H," the column enable signal COLEN is disabled, so that the LMs 11 are forcibly turned ON. Conversely, in a case where the all-LM forced-ON signal is "L" and the column enable signal COLEN also is "L," the output of the NOR gate 71 is "H." That is, in a case where the all-LM forced-ON signal is "L" and where the column enable signal COLEN is "L," the current on the VSL to the LMs 11 is cut off.

The CM 12 is connected with the output terminal of a NOR gate 72. The column enable signal COLEN is input to one input terminal of the NOR gate 72. The all-CM forced-ON signal for forcibly turning ON all CMs 12 is input to the other input terminal. When the output of the NOR gate 72 is "H," the current supplied to the CMs 12 is partially or totally cut off and turned OFF.

In a case where the all-CM forced-ON signal is "H," the output of the NOR gate 72 is "L" regardless of the column enable signal COLEN, so that the current supplied to the CMs 12 is not cut off. That is, in a case where the all-CM forced-ON signal is "H," the column enable signal COLEN is disabled and the CMs 12 are forcibly turned ON. In contrast, in a case where the all-CM forced-ON signal is "L" and the column enable signal COLEN also is "L," the output of the NOR gate 72 is "H." that is, in a case where the all-CM forced-ON signal is "L" and the column enable signal COLEN is "L," the current supplied to the CMs 12 is partially or totally cut off.

The CN 13 is connected with the output terminal of a NOR gate 73. The column enable signal COLEN is input to one input terminal of the NOR gate 73. The all-CN forced-ON signal for forcibly turning ON all CNs 13 is input to the other input terminal. When the output of the NOR gate 73 is "H," the supply of the input clock is stopped, so that the CNs 13 are turned OFF.

In a case where the all-CN forced-ON signal is "H," the output of the NOR gate 73 is "L" regardless of the column enable signal COLEN, so that the supply of the input clock is not stopped. That is, in a case where the all-CN forced-ON signal is "H," the column enable signal COLEN is disabled, so that the CNs 13 are forcibly turned ON. Conversely, in a case where the all-CN forded-ON signal is "L" and the column enable signal COLEN also is "L," the output of the NOR gate 73 is "H." That is, in a case where the all-CN forced-ON signal is "L" and the column enable signal COLEN also is "L," the supply of the input clock to the CNs 13 is stopped.

Given the above configuration, the column enable signal COLEN is used to control the power to each of the LM 11, CM 12, and CN 13 in the column AD section 5 for each column.

Alternatively, the column enable signal COLEN may be used to control power not to all of the LM 11, CM 12, and CN 13 but at least to some of these components for each column.

### <1-5. Examples of use and alternative examples>

What follows is a description of examples of use and alternative examples of the above-described solid-state imaging apparatus 1 according to the invention.

### (Examples of use)

In the solid-state imaging apparatus 1 of this embodiment according to the invention, necessary columns are operated, and the operations of unnecessary columns are stopped in the readout mode corresponding to the imaging mode.

FIG. 21 is a view explaining an example of using the solid-state imaging apparatus 1 according to the invention, in a surveillance camera.

The left side of FIG. 21 depicts column operations at the time when a surveillance camera operates in a motion detection mode.

In the motion detection mode, the pixels 2 of the pixel array section 3 are interpolated in units of pixel blocks in the H and V directions when read out. That is, the surveillance camera performs imaging at low resolution.

In a case where a motion is detected in a region of one or multiple pixel blocks in the motion detection mode, that pixel block is set as an ROI, and the surveillance camera transitions to an ROI readout mode as its imaging mode.

The right side of FIG. 21 depicts column operations at the time when the surveillance camera operates in the ROI readout mode.

In the ROI readout mode, the pixels 2 set in the pixel block in which a motion has been detected are read from the pixel array section 3. That is, the surveillance camera performs normal imaging of the ROI.

In this manner, the solid-state imaging apparatus 1 of this embodiment can be used in the surveillance camera that images, as the ROI, the region in which a motion is detected in the motion detection mode.

FIG. 22 is a view explaining another example of using the solid-state imaging apparatus 1 according to the invention, in the surveillance camera.

The left side of FIG. 22 depicts column operations at the time when the surveillance camera operates in a person detection mode.

In the person detection mode, the pixels 2 of the pixel array section 3 are interpolated in units of a predetermined number of columns in the H direction when read out.

In a case where the faces of multiple persons are detected in the person detection mode, multiple regions in which the faces are detected are set as ROIs, and the surveillance camera transitions to a multiple ROI readout mode as its imaging mode.

The right side of FIG. 22 depicts column operations at the time when the surveillance camera operates in the multiple ROI readout mode.

In the multiple ROI readout mode, the pixels 2 of the pixel array section 3 are read from the ROIs set in the regions in which the faces have been detected. In the right-side example in FIG. 22, in addition to H direction ROI readout, the pixel rows that do not include the ROIs in the V direction are arranged not to be selected. Incidentally, the target for detection in the person detection mode is not limited to the face but covers part or the entirety of the human body as well. For example, an entire human body, limbs such as arms or legs, or facial parts such as the eyes, nose, and mouth may be detected.

In this manner, the solid-state imaging apparatus 1 of this embodiment can be used in the surveillance camera that images, as ROIs, the regions in which faces are detected in the person detection mode.

### (Alternative examples)

In the H direction interpolation readout mode or in the H direction thinning-out readout mode, the columns targeted for readout may be switched in units of frames in order to suppress the load on the column AD sections 5 corresponding to the columns to be read out.

For example, as depicted in FIG. 23, the column AD sections 5 to be operated are shifted by one column at intervals of N frames in the H direction interpolation readout mode.

The above operation is implemented with the capability of setting the parameters COL_START and COL_END at intervals of N frames in H direction interpolation readout that uses the parameter COL_SKIP.

### <1-6. Configuration of the electronic device according to the present disclosure>

The application of the present disclosure is not limited to the solid-state imaging apparatus. This disclosure may also be applied to electronic devices. Here, the electronic devices refer to those having the imaging function such as mobile phones as well as camera systems including digital still cameras and digital video cameras. The present disclosure may further be applied to a modular form incorporated in the electronic devices. That is, the disclosure may be applied to the camera module.

Explained below with reference to FIG. 24 is an exemplary configuration of an electronic device to which the present disclosure is applied.

An electronic device 200 depicted in FIG. 24 includes an optical lens 201, a shutter apparatus 202, a solid-state imaging apparatus 203, a drive circuit 204, and a signal processing circuit 205. FIG. 24 illustrates an embodiment in which the above-described solid-state imaging apparatus 1 of this disclosure is incorporated in an electronic device (digital still camera) as the solid-state imaging apparatus 203.

The optical lens 201 forms, on an imaging plane of the solid-state imaging apparatus 203, an image derived from the image light (incident light) from a subject. The forming of the image causes a signal charge to be stored in the solid-state imaging apparatus 203 for a fixed time period. The shutter apparatus 202 controls a light emission period and a light blocking period for the solid-state imaging apparatus 203.

The drive circuit 204 supplies drive signals to the shutter apparatus 202 and to the solid-sate imaging apparatus 203. The drive signal supplied to the shutter apparatus 202 is a signal that controls shutter operations of the shutter apparatus 202. The drive signal supplied to the solid-sate imaging apparatus 203 is a signal that controls signal transfer operations of the solid-sate imaging apparatus 203. The solid-sate imaging apparatus 203 performs signal transfer in accordance with the drive signal (timing signal) supplied from the drive circuit 204. The signal processing circuit 205 performs diverse signal processing operations on the signal output from the solid-sate imaging apparatus 203. A video signal having undergone the signal processing is stored in a storage medium such as a memory or is output to a monitor.

In the electronic device 200 of this embodiment, the solid-state imaging apparatus 203 saves on power consumption without recourse to readout modes. As a result, a low-power-consumption electronic device is provided.

### <2. Second embodiment>

Incidentally, the AE (Auto Exposure) feature in the past has detected an optimum exposure time by varying the exposure time upon readout of an image of multiple frames.

For example, Japanese Patent Laid-open Nos. Hei 10-155112 and 2002-223386 disclose techniques for expanding the dynamic range of imaging by combining multiple images of different exposure amounts.

With the existing AE feature, it takes time to converge on an appropriate exposure. Moreover, the need for imaging multiple frames increases power consumption.

Explained below are configurations for implementing imaging with an optimum exposure at high speed with low power consumption.

### <2-1. Overview of the technology according to the present disclosure>

The technology according to the present disclosure involves calculating an optimum exposure time by performing imaging with an exposure time made different for each of multiple unit regions formed by dividing the pixel region within a single image frame.

FIG. 25 is a view explaining an overview of the technology according to the present disclosure.

The left side of FIG. 25 depicts shutter and read timings within one image frame. The right side of FIG. 25 illustrates one image frame acquired at the timings depicted on the left in the figure.

In the example of FIG. 25, the exposure time is varied for each of row unit regions formed by dividing the pixel region of a single frame into multiple rows.

Specifically, a single-frame pixel region is divided into N IT (Integration Time) units 0 to N-1 as the row unit regions from top to bottom. The shutter timing is staggered for each of the IT units.

In FIG. 25, reference characters IT_{base} denote a base exposure time serving as the reference; reference characters IT_UNIT_LEN represent the shutter time for each IT unit; and reference characters DIT stand for a difference (staggered difference) in exposure time between IT units. Here, the base exposure time IT_{base} is assumed to be the exposure time for IT unit 0 (row unit region at the top of the pixel region).

In this case, the exposure time IT(n) for IT unit n (n ranges from 0 to N-1) is expressed as IT_{base} - DIT × n.

That is, as depicted on the left side of FIG. 25, the shutter timing for each IT unit is staggered in a manner closer to the read timing (in a manner shortening the exposure time) the farther the IT unit shifts in position from 0 to N-1 in the pixel region.

In this manner, as depicted on the right side of FIG. 25, there is obtained a single frame in which different IT units have different levels of brightness, with IT unit 0 being the brightest and IT unit N-1 being the darkest.

Thus, with the technology according to the present disclosure, an optimum exposure time in a given environment is calculated on the basis of the pixel values of each of the IT units. Following the calculation, the next and subsequent frames are imaged with the calculated optimum exposure time.

In the following description, the term "one-frame AE" is used to mean the act of performing imaging with an exposure time made different for each of unit regions in a single image frame so as to calculate an optimum exposure time.

### <2-2. Configuration of the solid-state imaging apparatus>

FIG. 26 is a block diagram depicting an exemplary configuration of a solid-state imaging apparatus according to the present disclosure.

A solid-state imaging apparatus 1001 is configured as a CMOS (Complementary Metal Oxide Semiconductor) image sensor that performs imaging by use of the rolling shutter technique.

The solid-state imaging apparatus 1001 includes an imaging element 1002, a pixel drive section 1003, an ADC (AD conversion section) 1004, an input processing section 1005, an image processing section 1006, and an output IF (Interface) 1007.

The imaging element 1002 is configured with multiple pixels arrayed two-dimensionally.

The pixel drive section 1003 performs imaging by driving the pixels constituting the imaging element 1002. Specifically, the pixel drive section 1003 drives the pixels in units of unit regions formed by dividing the pixel region (region corresponding to all pixels associated with the imaging of the imaging element 1002) in a single image frame, and drives the pixels from the next frame on with the above-described optimum exposure time.

The ADC 1004 is configured with AD conversion circuits each arranged for each of the pixel columns in the imaging element 1002. The ADC 1004 performs signal processing such as signal amplification and AD conversion on the pixel signal (analog signal) output from one row of pixels per column.

The input processing section 1005 inputs the image signal (digital signal) supplied from the ADC 1004 to the image processing section 1006 sequentially. The image processing section 1006 performs image processing on the image signal input from the input processing section 1005, and outputs the processed signal via the output IF 1007. The image processing section 1006 may perform buffering alone or may carry out diverse digital signal processing operations such as black level adjustment, column variation correction, and signal amplification.

The solid-state imaging apparatus 1001 further includes an evaluation value calculation section 1008 and an exposure parameter calculation section 1009.

The evaluation value calculation section 1008 calculates, on the basis of the image signal input from the input processing section 1005, an evaluation value for evaluating the exposure time (IT) for each IT unit from the pixel values at intervals of unit regions (IT units) used in one-frame AE.

The exposure parameter calculation section 1009 calculates an optimum exposure time on the basis of the evaluation value for each IT unit calculated by the evaluation value calculation section 1008. Also, the exposure parameter calculation section 1009 calculates an analog signal amplification factor for the ADC 1004 and a digital signal amplification factor for the image processing section 1006 corresponding to the calculated optimum exposure time. The exposure parameters including the calculated optimum exposure time, analog signal amplification factor, and digital signal amplification factor are supplied to the pixel drive section 1003, to the ADC 1004, and to the image processing section 1006.

The solid-state imaging apparatus 1001 further includes a control section 1010. The control section 1010 is configured with a CPU (Central Processing unit), for example. The control section 1010 controls the pixel drive section 1003, the ADC 1004, the input processing section 1005, the image processing section 1006, the output IF 1007, the evaluation value calculation section 1008, and the exposure parameter calculation section 1009.

For example, the control section 1010 determines whether to perform one-frame AE, ordinary AE using multiple frames, or normal imaging by controlling the pixel drive section 1003, the evaluation value calculation section 1008, and the exposure parameter calculation section 1009.

Explained below are detailed configurations of the pixel drive section 1003, the evaluation value calculation section 1008, and the exposure parameter calculation section 1009.

### <2-3. Configuration of the pixel drive section>

FIG. 27 is a block diagram depicting an exemplary configuration of the pixel drive section 1003.

The pixel drive section 1003 includes a state control section 1021, a shutter row address counter 1022, a read row address counter 1023, a row address decoder 1024, a row driver 1025, and a shutter hold 1026.

The state control section 1021 controls the drive state (shutter drive, read drive) of the pixels in the imaging element 1002 by controlling the operations of the shutter row address counter 1022 and the read row address counter 1023.

Under control of the state control section 1021, the shutter row address counter 1022 sequentially designates the pixel rows, from top to bottom for example, for shutter drive.

Under control of the state control section 1021, the read row address counter 1023 sequentially designates the pixel rows, from top to bottom, for example, for read drive.

The row address decoder 1024 selects the pixel rows for shutter drive on the basis of the designation by the shutter row address counter 1022. Also, the row address decoder 1024 selects the pixel rows for read drive on the basis of the designation by the read row address counter 1023.

The row driver 1025 supplies a drive signal to the pixel rows selected by the row address decoder 1024, thereby driving the pixels in the selected pixel rows.

In a case where the control section 1010 determines that one-frame AE is to be performed, the shutter hold 1026 supplies a counter hold signal to the shutter row address counter 1022 under control of the state control section 1021.

As depicted in FIG. 28, the counter hold signal is "H" (High) during the period of the staggered difference in exposure time DIT between the IT units at the time of shutter drive, and is "L" (Low) during the period of the shutter time IT_UNIT_LEN for each IT unit.

During the period in which the counter hold signal is "H," the shutter row address counter 1022 stops its operation. In this manner, the pixel drive section 1003 staggers the shutter timing for each of the IT units when one-frame AE is performed. This can shorten the exposure time in stages.

### <2-4. Configuration of the evaluation value calculation section>

FIG. 29 is a block diagram depicting an exemplary configuration of the evaluation value calculation section 1008.

The evaluation value calculation section 1008 includes a row luminance mean value calculation section 1031 and a unit luminance mean value calculation section 1032.

The row luminance mean value calculation section 1031 calculates a row luminance mean value, which is an average of the luminance values of the pixels in each pixel row, on the basis of the image signal obtained by performing imaging with an exposure time made different for each of the IT units in a single frame. The row luminance mean value calculated for each pixel row is supplied to the unit luminance mean value calculation section 1032.

The unit luminance mean value calculation section 1032 calculates a unit luminance mean value, which is an average of the row luminance mean values for each IT unit, on the basis of the row luminance mean value for each pixel row. The row luminance mean value calculated for each IT unit is supplied to the exposure parameter calculation section 1009 as an evaluation value of the exposure time for each IT unit.

In the following description, the evaluation value of the exposure time for each IT unit is expressed as the OPD (Optical Detect) value, and the OPD value of IT unit n is represented by OPD(n).

### <2-5. Configurations of the exposure parameter calculation section>

### (First exemplary configuration)

FIG. 30 is a block diagram depicting a first exemplary configuration of the exposure parameter calculation section 1009.

The exposure parameter calculation section 1009 in FIG. 30 includes an OPD value composition section 1041 and a determination section 1042.

The OPD value composition section 1041 composes the OPD values within a predetermined effective range of the OPD values for the IT units in order to calculate an OPD composite value, which is an evaluation value of the exposure time for the entire frame.

Explained below with reference to FIG. 31 is the composition of OPD values by the OPD value composition section 1041.

FIG. 31 is a view plotting the OPD values of the exposure time IT(n) for the IT units. The shorter the exposure time, the smaller the OPD value is set.

The OPD value composition section 1041 composes the OPD values within the effective range defined by a predetermined upper limit value and a predetermined lower limit value. Because the OPD values are saturated near a maximum OPD value, these values are not included in the effective range.

Techniques that apply HDR (High Dynamic Range) composition are used for composing the OPD values. This makes it possible to calculate an OPD composite value of the high dynamic range free of the effect of saturation.

Returning to the explanation of FIG. 30, the determination section 1042 determines an optimum exposure time, an analog signal amplification factor, and a digital signal amplification factor by use of the OPD composite value calculated by the OPD value composition section 1041. The determination section 1042 outputs what is thus determined as the exposure parameters.

Explained below with reference to FIG. 32 is how the exposure parameters are determined.

FIG. 32 depicts the exposure gain (total gain) corresponding to the OPD composite value, as well as the (optimum) exposure time, analog signal amplification factor, and digital signal amplification factor for obtaining the total gain. The relation between the OPD composite value and the total gain is set beforehand in a manner attaining an appropriate exposure corresponding to the OPD composite value.

Given the relation depicted in FIG. 32, the determination section 1042 determines the optimum exposure time, analog signal amplification factor, and digital signal amplification factor for attaining the appropriate exposure through the use of the OPD composite value calculated by the OPD value composition section 1041.

The above configuration permits one-frame AE, thereby making it possible to perform imaging from the next frame on with an optimum exposure at high speed with low power consumption.

### Second exemplary configuration

FIG. 33 is a block diagram depicting a second exemplary configuration of the exposure parameter calculation section 1009.

The exposure parameter calculation section 1009 in FIG. 33 includes an optimum IT calculation section 1051 and a conversion section 1052.

The optimum IT calculation section 1051 calculates an optimum IT on the basis of the exposure time IT(n) corresponding to OPD values closer to a predetermined target value from among the OPD values for the IT units.

Explained below with reference to the flowchart of FIG. 34 is an optimum IT calculation process performed by the optimum IT calculation section 1051.

In step S1001, IT number n, the IT upper value, IT lower value, target OPD upper value, and target OPD lower value are all set to zero.

Here, as depicted in FIG. 35, a target OPD value is set to be the target value for the OPD values. The target OPD upper value is the OPD value closest to the target OPD value from among the OPD values that are larger than the target OPD value. The target OPD lower value is the OPD value closest to the target OPD value from among the OPD values that are smaller than the target OPD value. The IT upper value is the IT corresponding to the target OPD upper value, and the IT lower value is the IT corresponding to the target OPD lower value.

In step S1002, it is determined whether or not OPD(n)(initially OPD(0)) is equal to the target OPD value.

In a case where OPD(n) is determined to be equal to the target OPD value, control is transferred to step S1003. In step S1003, IT(n) corresponding to OPD(n) equal to the target OPD value is regarded as the optimum IT. This brings the processing to an end.

Conversely, in a case where OPD(n) is determined to be not equal to the target OPD value, control is transferred to step S1004. In step S1004, it is determined whether or not OPD(n) is smaller than the target OPD value.

In a case where OPD(n) is determined to be not smaller than the target OPD value, control is transferred to step S1005. In step S1005, it is determined whether or not n = N - 1.

In a case where it is not determined that n = N - 1, control is transferred to step S1006. In step S1006, IT(n) is set to be the IT upper value, and OPD(n) is set to be the target OPD upper value.

Thereafter in step S1007, the number n is incremented by 1. Control is then returned to step S1002 and the subsequent steps are repeated.

Meanwhile, in a case where OPD(n) is determined to be smaller than the target OPD value in step S1004 or where it is determined that n = N - 1 in step S1005, control is transferred to step S1008.

In step S1008, IT(n) is set to be the IT lower value, and OPD(n) is set to be the target OPD lower value.

In the manner described above, a search is made for the target OPD upper value and the target OPD lower value sandwiching the target OPD value therebetween.

Thereafter in step S1009, the optimum IT is given as: (IT upper value - IT lower value)/(target OPD upper value - target OPD lower value) × (target OPD value). This brings the processing to an end.

Returning to the explanation of FIG. 33, the conversion section 1052 converts the optimum IT calculated by the optimum IT calculation section 1051 into the optimum exposure time, the analog signal amplification factor, and the digital signal amplification factor, and outputs what is converted as the exposure parameters. Specifically, the conversion section 1052 regards the optimum IT as the optimum exposure time and, using the relation depicted in FIG. 32, for example, obtains the analog signal amplification factor and the digital signal amplification factor corresponding to the optimum exposure time.

The above configuration permits one-frame AE, thereby making it possible to perform imaging from the next frame on with an optimum exposure at high speed with low power consumption.

### <2-6. Examples of use>

The above-described solid-state imaging apparatus 1001 performing one-frame AE can be used in an event-driven surveillance camera.

Some examples of use of the solid-state imaging apparatus 1001 are explained below.

### (First example of use)

Explained below with reference to the flowchart of FIG. 36 is how the solid-state imaging apparatus 1001 operates when used in a surveillance camera that has, as one of its imaging modes, the motion detection mode for detecting a motion within an imaging range. The process in FIG. 36 is started when the solid-state imaging apparatus 1001 is in a standby mode.

In step S1011, the control section 1010 determines whether or not a motion is detected within the imaging range.

The process in step S1011 is repeated until a motion is determined to be detected. Upon determination of a motion, control is transferred to step S1012.

In step S1012, the control section 1010 performs one-frame AE by controlling the pixel drive section 1003, the evaluation value calculation section 1008, and the exposure parameter calculation section 1009.

In step S1013 following one-frame AE, the control section 1010 reads an image by performing normal imaging from the next frame on with the optimum exposure time calculated by the one-frame AE.

In step S1014, the control section 1010 determines whether or not a predetermined time has elapsed since the motion has been detected within the imaging range. In step S1014, the control section 1010 may determine whether or not motion detection has ceased within the imaging range.

If the predetermined time has yet to elapse or while the motion is still being detected, the process in step S1013 is repeated, and normal imaging is continued.

Conversely, in a case where the predetermined time has elapsed or where motion detection has ceased, control is transferred to step S1015. In step S1015, the control section 1010 causes the solid-state imaging apparatus 1001 to transition to the standby mode. Control is then returned to step S1011.

In the above processing, one-frame AE is performed at the time when a motion is detected in the standby mode, followed by normal imaging. This makes it possible to monitor moving bodies with an optimum exposure at high speed with low power consumption.

### (Second example of use)

Explained below with reference to the flowchart of FIG. 37 is how the solid-state imaging apparatus 1001 operates when used in a surveillance camera that has, as one of its imaging modes, a time-lapse imaging mode for generating a single moving image by joining together multiple still images acquired consecutively at intervals of a fixed time period. The process in FIG. 37 is started when the solid-state imaging apparatus 1001 is in the standby mode.

In step S1021, the control section 1010 starts and continues time count until a fixed time elapses.

In step S1022, the control section 1010 determines whether the fixed time has elapsed and the time count has ended.

The process in step S1022 is repeated until the count is determined to have ended. After the determination that the count has ended, control is transferred to step S1023.

In step S1023, the control section 1010 performs one-frame AE by controlling the pixel drive section 1003, the evaluation value calculation section 1008, and the exposure parameter calculation section 1009.

In step S1024 following one-frame AE, the control section 1010 reads an image by performing normal imaging from the next frame on with the optimum exposure time calculated by the one-frame AE. Here, an image of one or several frames is read out as a still image.

With the image of one or several frames read out, control is transferred to step S1025. In step S1025, the control section 1010 causes the solid-state imaging apparatus 1001 to transition to the standby mode. Control is then returned to step S1021.

In the above processing, one-frame AE is performed at intervals of a fixed time period, followed by imaging of a still image of one or several frames. This makes it possible to perform time-lapse imaging with an optimum exposure at high speed with low power consumption.

### (Third example of use)

Explained below with reference to the flowchart of FIG. 38 is how the solid-state imaging apparatus 1001 operates when used in a surveillance camera that has, as one of its imaging modes, operation mode for performing AE in accordance with a significant change in illuminance that may occur when a light is turned on, for example. The process in FIG. 38 is started when the solid-state imaging apparatus 1001 is performing normal imaging.

In step S1031, the control section 1010 determines whether or not a change in illuminance is detected.

When an illuminance change is determined to be detected, control is transferred to step S1032.

In step S1032, the control section 1010 determines whether or not the illuminance change exceeds a predetermined threshold value.

If the illuminance change is determined to exceed the threshold value, control is transferred to step S1033. In step S1033, the control section 1010 performs one-frame AE by controlling the pixel drive section 1003, the evaluation value calculation section 1008, and the exposure parameter calculation section 1009.

In step S1034 following one-frame AE, the control section 1010 reads an image by performing normal imaging from the next frame on with the optimum exposure time calculated by the one-frame AE.

Conversely, if it is determined in step S1032 that the illuminance change does not exceed the threshold value, control is transferred to step S1035. In step S1035, the control section 1010 performs ordinary AE using multiple frames by controlling the pixel drive section 1003.

Thereafter, in step S1034, the control section 1010 reads an image by performing normal imaging from the next frame on with the exposure time obtained by the ordinary AE.

Also, in a case where an illuminance change is determined to be not detected in step S1031, control is transferred to step S1034. In step S1034, the control section 1010 reads an image by performing normal imaging with the same exposure time as before.

In the above processing, one-frame AE is performed at the time when a significant illuminance change is detected, followed by normal imaging. This makes it possible to perform imaging with an optimum exposure at high speed with low power consumption even in an environment where abrupt illuminance changes occur.

### <2-7. Alternative examples>

Alternative examples of the above-described solid-state imaging apparatus 1001 are explained below.

### (Spot AE)

In the above description, it has been explained that the pixel region targeted for one-frame AE corresponds to the entire pixels of the imaging element 1002. Alternatively, the targeted pixel region may be a spot region constituted by part of all the pixels.

For example, as depicted in FIG. 39, one-frame AE may be performed on an ROI (region of interest) 1101 set as a result of the detection of a person's face. In this case, only the pixels of the pixel rows in the vertical direction (V direction) of the ROI 1101 are driven, and only the pixel columns in the horizontal direction (H direction) of the ROI 1101 are read out. Incidentally, the target for which the ROI 1101 is set is not limited to the face. The target may alternatively be an entire human body, limbs such as arms or legs, or facial parts such as the eyes, the nose, and the mouth.

### (Measures taken where there is a large difference in illuminance between the top and the bottom of the imaging range)

In the above-described embodiment, one-frame AE is performed with the exposure time made shorter from top to bottom of the pixel region constituting the imaging range. However, in a case where there is a large difference in illuminance between the top and the bottom of the imaging range, one-frame AE may not be properly carried out.

In such a case, as depicted in FIG. 40, the exposure time may be set in two stages (long exposure and short exposure) for each of the IT units.

In FIG. 40, reference characters DIT denote a staggered difference in exposure time in the first stage between IT units, and reference characters DIT2 represent a difference in exposure time (partial difference) between the first and the second stages for each IT unit.

In this case, the exposure time IT(n) of the first stage for IT unit n is expressed as IT_{base} - DIT × n, and the exposure time IT2(n) of the second stage for IT unit n is expressed as IT_{base} - (DIT × n + DIT2) . However, in a case where IT2 (n) < 0, IT2(n) is expressed as IT2(n) + IT_{base}.

With the above measures taken, even in a case where there is a large difference in illuminance between the top and the bottom of the imaging range, one-frame AE is carried out appropriately.

### (Read timing control)

In the above-described embodiment, the shutter timing is staggered for each of the IT units. Alternatively, it may be the read timing that is staggered for each of the IT units.

In this case, as depicted in FIG. 41, the shutter hold 1026 under control of the state control section 1021 supplies the counter hold signal to the read row address counter 1023.

Specifically, as depicted in FIG. 42, the counter hold signal is "H" during the period of the staggered difference in exposure time DIT between IT units at the time of read drive, and is "L" during the period of the read time IT_UNIT_LEN for each of the IT units.

Note that, in the example of FIG. 42, the exposure time IT (n) for IT unit n is expressed as IT_{base} + DIT × n.

During the period in which the counter hold signal is "H," the read row address counter 1023 stops its operation. This allows the pixel drive section 1003, at the time of performing one-frame AE, to prolong the exposure time in stages by staggering the read timing for each of the IT units.

### (Shutter timing control and read timing control)

The shutter timing and the read timing may both be staggered for each of the IT units.

In this case, as depicted in FIG. 43, the shutter hold 1026 under control of the state control section 1021 supplies a shutter counter hold signal to the shutter row address counter 1022 and a read counter hold signal to the read row address counter 1023.

Specifically, as depicted in FIG. 44, the shutter counter hold signal is "H" during the period of a staggered difference in exposure time DIT1 between IT units and is "L" during the period of a shutter time IT_UNIT_LEN1 for each IT unit at the time of shutter drive. The read counter hold signal is "H" during the period of the staggered difference in exposure time DIT2 between IT units and is "L" during the period of a read time IT_UNIT_LEN2 for each IT unit at the time of read drive.

During the period in which the shutter counter hold signal is "H," the shutter row address counter 1022 stops its operation. During the period in which the read counter hold signal is "H," the read row address counter 1023 stops its operation. Especially, in the example of FIG. 44, the shutter timing and the read timing are staggered for each half region (pixel row) in the V direction of each of the IT units. This allows the pixel drive section 1003, at the time of performing one-frame AE, to shorten the exposure time in stages for the half region of each of the IT units.

### (Gain control in the H direction)

In the above-described one-frame AE, a single frame is obtained by changing the exposure time for each of the IT units such that the brightness of the frame may be varied in the V direction. Alternatively, one frame can be obtained with its brightness also varied in the H direction.

In this case, as depicted in FIG. 45, a gain control section 1112 is provided to control the gain of an amplifier 1111 arranged for each of the columns.

For example, as depicted in FIG. 46, the gain control section 1112 divides each of the IT units into three blocks in the H direction, and controls the gain of each of the H-direction blocks in each IT unit. In the example of FIG. 46, the gain of the center H-direction block is made larger, and the gain of the right-side H-direction block is made still larger, than the gain of the left-side H-direction block serving as the reference in each IT unit. Furthermore, the gain of the center H-direction block and the gain of the right-side H-direction block are increased progressively from top to bottom of a single frame in each of the IT units.

In one-frame AE, as described above, it is possible to obtain one frame of which the brightness is varied not only in the V direction but also in the H direction, thereby increasing the gain width.

### (Usage in an image sensor operating by the area ADC method)

The solid-state imaging apparatus 1001 of this embodiment may be configured as an image sensor operating by the area ADC method in which each frame is subjected to AD conversion in units of areas.

In this case, in the pixel drive section 1003 depicted in FIG. 47, a shutter area address counter 1131 under control of the state control section 1021 designates sequentially the area targeted for shutter drive.

A read area address counter 1132 under control of the state control section 1021 designates sequentially the area targeted for read drive.

An area address decoder 1133 selects the area for shutter drive on the basis of the designation by the shutter area address counter 1131. Also, the area address decoder 1133 selects the area for read drive on the basis of the designation by the read area address counter 1132.

An area driver 1134 drives the pixels of the area selected by the area address decoder 1133 by supplying a drive signal to that area.

A shutter hold 1135 under control of the state control section 1021 supplies the counter hold signal to the shutter area address counter 1131.

In this case, one-frame AE is performed with the exposure time varied for each of the areas.

In the example of FIG. 48, the exposure time is varied for each of 20 areas formed by dividing one frame into four areas in the H direction and five areas in the V direction. Specifically, the shutter timing is controlled in such a manner that the exposure time is shortened in stages from area No. 1 to area No. 20.

Further, in the example of FIG. 48, an evaluation value is calculated on the basis of the pixel values of each of the areas. An optimum exposure time is then calculated on the basis of the evaluation value for each of the areas.

In one-frame AE, as described above, the exposure time can be varied not only in the V direction but also in the H direction.

Furthermore, the configuration in FIG. 47 permits one-frame AE on the ROI set within the imaging range.

In the example FIG. 49, an ROI 1151 is set using nine areas constituted by areas Nos. 13 to 15, 21 to 23, and 29 to 31 out of 48 areas formed by dividing one frame into six areas in the H direction and eight areas in the V direction.

Further, in the example of FIG. 49, an evaluation value is calculated on the basis of the pixel values of each area included in the ROI 1151. An optimum exposure time is then calculated on the basis of the evaluation value for each of the areas.

In this manner, the image sensor operating by the ADC method can be arranged to perform one-frame AE targeted only for the ROI.

### <2-8. Configuration of the electronic device according to the present disclosure>

The application of the present disclosure is not limited to the solid-state imaging apparatus. This disclosure can also be applied to electronic devices. Here, the electronic devices refer to those having the imaging function such as mobile phones as well as camera systems including digital still cameras and digital video cameras. The present disclosure may further be applied to a modular form incorporated in the electronic devices. That is, the disclosure may be applied to the camera module.

An exemplary configuration of an electronic device to which the present disclosure is applied is explained below with reference to FIG. 50.

An electronic device 1200 depicted in FIG. 50 includes an optical lens 1201, a shutter apparatus 1202, a solid-state imaging apparatus 1203, a drive circuit 1204, and a signal processing circuit 1205. FIG. 50 illustrates an embodiment in which the above-described solid-state imaging apparatus 1001 of this disclosure is incorporated in an electronic device (digital still camera) as the solid-state imaging apparatus 1203.

The optical lens 1201 forms, on an imaging plane of the solid-state imaging apparatus 1203, an image derived from the image light (incident light) from a subject. The forming of the image causes a signal charge to be stored in the solid-state imaging apparatus 1203 for a fixed time period. The shutter apparatus 1202 controls a light emission period and a light blocking period for the solid-state imaging apparatus 1203.

The drive circuit 1204 supplies drive signals to the shutter apparatus 1202 and solid-sate imaging apparatus 1203. The drive signal supplied to the shutter apparatus 1202 is a signal that controls shutter operations of the shutter apparatus 1202. The drive signal supplied to the solid-sate imaging apparatus 1203 is a signal that controls signal transfer operations of the solid-sate imaging apparatus 1203. The solid-sate imaging apparatus 1203 performs signal transfer in accordance with the drive signal (timing signal) supplied from the drive circuit 1204. The signal processing circuit 1205 performs diverse signal processing operations on the signal output from the solid-sate imaging apparatus 1203. A video signal having undergone the signal processing is stored in a storage medium such as a memory or is output to a monitor.

In the electronic device 1200 of this embodiment, the solid-state imaging apparatus 1203 can perform imaging with an optimum exposure at high speed with lower power consumption. As a result, a low-power-consumption electronic device can be provided.

Note that the embodiments of the present disclosure are not limited to those discussed above. The embodiments may be modified, altered, or improved in diverse fashion within the scope of the present disclosure The invention is defined by the appended claims.

### [Reference Signs List]

### 1 Solid-state imaging apparatus, 2 Pixel

3 Pixel array section, 5 Column AD section, 6 Column enable control section, 11 Load MOS transistor, 12 Comparator, 13 Counter, 30 CPU, 31 Controller, 32 Register, 40 CPU, 41 Shift controller, 42 Shift register, 50 CPU, 51 Skip decoder, 52 Comparator, 60 CPU, 61 Skip decoder, 62 Comparator, 200 Electronic device, 203 Solid-state imaging apparatus, 1001 Solid-state imaging apparatus, 1002 Imaging element, 1003 Pixel drive section, 1004 ADC, 1006 Image processing section, 1008 Evaluation value calculation section, 1009 Exposure parameter calculation section, 1010 Control section, 1200 Electronic device, 1203 Solid-state imaging apparatus.

## Claims

1. A solid-state imaging apparatus (1) comprising:
a pixel array section (3);
a column AD section (5) configured to be arranged for each of columns in the pixel array section (3); and
a column enable control section (6) configured to programmably control operations of the column AD sections (5) in accordance with an imaging mode, wherein
the column enable control section (6) is configured to control the operations of the column AD sections (5) in accordance with a position of a region of interest of the imaging mode, and the region of interest includes a region in which a motion is detected in a motion detection mode or includes a region in which an entirety or part of a human body is detected in a person detection mode, and
wherein the column enable control section (6) is configured to control the operations of the column AD sections (5) in the motion detection mode by thinning-out pixels in the pixel array section (3) in units of pixel blocks in a horizontal, H, direction and a vertical, V, direction when read out, and, when a motion is detected in a region of one or multiple pixel blocks, setting that pixel block as a region of interest by operating of the column AD sections (5) corresponding to columns of the region of interest during readout, and by stopping operations of the column AD sections (5) corresponding to columns other than columns of the region of interest during readout of the region of interest,
the column enable control section (6) being further configured to control the operations of the column AD sections (5) in the person detection mode by thinning-out pixels of the pixel array section (3) in units of a predetermined number of columns in the H direction when read out, and, when faces of multiple persons are detected, setting multiple regions in which the faces are detected as regions of interest, by operating of the column AD sections (5) corresponding to columns of the region of interest during readout, and by stopping operations of the column AD sections (5) corresponding to columns other than columns of the regions of interest during readout of the regions of interest.

2. The solid-state imaging apparatus (1) according to claim 1, wherein
the column enable control section (6) controls output of an operation signal for operating the column AD sections (5) on a basis of a plurality of parameters.

3. The solid-state imaging apparatus (1) according to claim 2, wherein
the plurality of parameters includes a column number of the column positioned at one end of the consecutive columns targeted for readout and a column number of the column positioned at the other end thereof.

4. The solid-state imaging apparatus (1) according to claim 2 or 3, wherein
the plurality of parameters includes the number of the consecutive columns not targeted for readout from among the individual columns targeted for periodical readout.

5. The solid-state imaging apparatus (1) according to any one of claims 2 to 4, wherein
the plurality of parameters includes the column number of the column at one end of the consecutive columns not targeted partially for readout, and the number of the consecutive columns not targeted partially for readout.

6. The solid-state imaging apparatus (1) according to any one of claims 2 to 5, wherein
the column enable control section (6) has registers for outputting the operation signal to the column AD sections (5).

7. The solid-state imaging apparatus (1) according to any one of claims 2 to 5, wherein
the column enable control section (6) has shift registers including flip-flops for outputting the operation signal to the column AD sections (5).

8. The solid-state imaging apparatus (1) according to any one of the preceding claims, wherein
the column AD sections (5) include load MOS transistors (11), and
the column enable control section (6) cuts off a current supplied to the load MOS transistors (11) included in the column AD sections (5) corresponding to the columns not to be operated.

9. The solid-state imaging apparatus (1) according to any one of claims 1 to 7, wherein
the column AD sections (5) include comparators (12), and
the column enable control section (6) partially or totally cuts off a current supplied to the comparators (12) included in the column AD sections (5) corresponding to the columns not to be operated.

10. The solid-state imaging apparatus (1) according to any one of claims 1 to 7, wherein
the column AD sections (5) include counters (13), and
the column enable control section (6) stops supplying an input clock to the counters (13) included in the column AD sections (5) corresponding to the columns not to be operated.

11. A method of controlling a solid-state imaging apparatus (1)according to claim 1, the method comprising:
programmably controlling operations of a column AD section (5) arranged for each of columns in a pixel array section (3) in accordance with an imaging mode, and further comprising
controlling the operations of the column AD sections (5) in accordance with a position of a region of interest set in accordance with the imaging mode, and the region of interest includes a region in which a motion is detected in a motion detection mode or includes a region in which an entirety or part of a human body is detected in a person detection mode, and
controlling the operations of the column AD sections (5) in the motion detection mode by thinning-out pixels in the pixel array section (3) in units of pixel blocks in a horizontal, H, direction and a vertical, V, direction when read out, and, when a motion is detected in a region of one or multiple pixel blocks, setting that pixel block as a region of interest by operating of the column AD sections (5) corresponding to columns of the region of interest during readout,
and by stopping operations of the column AD sections (5) corresponding to columns other than columns of the region of interest during readout of the region of interest,
and
controlling the operations of the column AD sections (5) in the person detection mode by thinning-out pixels of the pixel array section (3) in units of a predetermined number of columns in the H direction when read out, and, when faces of multiple persons are detected, setting multiple regions in which the faces are detected as regions of interest, by operating of the column AD sections (5) corresponding to columns of the regions of interest during readout and by stopping operations of the column AD sections (5) corresponding to columns other than columns of the regions of interest during readout of the regions of interest.

12. An electronic device (1200) comprising:
a solid-state imaging apparatus (1) according to any of claims 1 to 10.

## Patentansprüche

1. Festkörperbildgebungseinrichtung (1), umfassend:
einen Pixelarray-Abschnitt (3);
einen Spalten-AD-Abschnitt (5), der konfiguriert ist, um für jede der Spalten in dem Pixelarray-Abschnitt (3) angeordnet zu werden; und
einen Spaltenfreigabesteuerabschnitt (6), der konfiguriert ist, um Operationen der Spalten-AD-Abschnitte (5) gemäß einem Bildgebungsmodus programmierbar zu steuern, wobei
der Spaltenfreigabesteuerabschnitt (6) konfiguriert ist, um die Operationen der Spalten-AD-Abschnitte (5) gemäß einer Position eines interessierenden Bereichs des Bildgebungsmodus zu steuern, und der interessierende Bereich einen Bereich, in dem eine Bewegung in einem Bewegungserfassungsmodus erfasst wird, einschließt oder einen Bereich, in dem eine Gesamtheit oder ein Teil eines menschlichen Körpers in einem Personenerfassungsmodus erfasst wird, einschließt und
wobei der Spaltenfreigabesteuerabschnitt (6) konfiguriert ist, um die Operationen der Spalten-AD-Abschnitte (5) in dem Bewegungserfassungsmodus durch Ausdünnen von Pixeln in dem Pixelarray-Abschnitt (3) in Einheiten von Pixelblöcken in einer horizontalen Richtung, H-Richtung, und einer vertikalen Richtung, V-Richtung, wenn ausgelesen, zu steuern, und, wenn eine Bewegung in einem Bereich von einem oder mehreren Pixelblöcken erfasst wird, diesen Pixelblock als eine interessierende Region durch Betreiben der Spalten-AD Abschnitte (5), die den Spalten des interessierenden Bereichs entsprechen, während des Auslesens und durch Stoppen von Operationen der Spalten-AD-Abschnitte (5), die Spalten entsprechen, die andere als Spalten des interessierenden Bereichs sind, während des Auslesens des interessierenden Bereichs einzustellen,
wobei der Spaltenfreigabesteuerabschnitt (6) ferner konfiguriert ist, um die Operationen der Spalten-AD-Abschnitte (5) in dem Personenerfassungsmodus durch Ausdünnen von Pixeln in dem Pixelarray-Abschnitt (3) in Einheiten einer vorbestimmten Anzahl von Spalten in der H-Richtung, wenn ausgelesen, zu steuern und, wenn Gesichter mehrerer Personen erfasst werden, mehrere Bereiche, in denen Gesichter erfasst werden, durch Betreiben der Spalten-AD Abschnitte (5), die den Spalten des interessierenden Bereichs entsprechen, während des Auslesens und durch Stoppen von Operationen der Spalten-AD-Abschnitte (5), die Spalten entsprechen, die andere als Spalten der interessierenden Bereiche sind, während des Auslesens des interessierenden Bereichs als interessierende Bereiche einzustellen.

2. Festkörperbildgebungseinrichtung (1) nach Anspruch 1, wobei
der Spaltenfreigabesteuerabschnitt (6) eine Ausgabe eines Betriebssignals zum Betreiben der Spalten-AD-Abschnitte (5) auf einer Basis einer Vielzahl von Parametern steuert.

3. Festkörperbildgebungseinrichtung (1) nach Anspruch 2, wobei
die Vielzahl von Parametern eine Spaltenzahl der Spalte, die an einem Ende der aufeinanderfolgenden Spalten, auf die das Auslesen abzielt, positioniert ist und eine Spaltenzahl der Spalte, die an dem anderen Ende davon positioniert ist, einschließt.

4. Festkörperbildgebungseinrichtung (1) nach Anspruch 2 oder 3, wobei
die Vielzahl von Parametern die Anzahl der aufeinanderfolgenden Spalten, auf die das Auslesen nicht abzielt, von den einzelnen Spalten, auf die das periodische Auslesen abzielt, einschließt.

5. Festkörperbildgebungseinrichtung (1) nach einem der Ansprüche 2 bis 4, wobei
die Vielzahl von Parametern die Spaltenzahl der Spalte an einem Ende der aufeinanderfolgenden Spalten, auf die das Auslesen nicht teilweise abzielt, und die Anzahl der aufeinanderfolgenden Spalten, auf die das Auslesen nicht teilweise abzielt, einschließt.

6. Festkörperbildgebungseinrichtung (1) nach einem der Ansprüche 2 bis 5, wobei
der Spaltenfreigabesteuerabschnitt (6) Register zum Ausgeben des Betriebssignals an die Spalten-AD-Abschnitte (5) aufweist.

7. Festkörperbildgebungseinrichtung (1) nach einem der Ansprüche 2 bis 5, wobei
der Spaltenfreigabesteuerabschnitt (6) Schieberegister, die Flip-Flops zum Ausgeben des Betriebssignals an die Spalten-AD-Abschnitte (5) einschließen, aufweist.

8. Festkörperbildgebungseinrichtung (1) nach einem der vorstehenden Ansprüche, wobei
die Spalten-AD-Abschnitte (5) Last-MOS-Transistoren (11) einschließen und
der Spaltenfreigabesteuerabschnitt (6) einen Strom trennt, der den Last-MOS-Transistoren (11) zugeführt wird, die in den Spalten-AD-Abschnitten (5) eingeschlossen sind, die den nicht zu betreibenden Spalten entsprechen.

9. Festkörperbildgebungseinrichtung (1) nach einem der Ansprüche 1 bis 7, wobei
die Spalten-AD-Abschnitte (5) Komparatoren (12) einschließen und
der Spaltenfreigabesteuerabschnitt (6) einen Strom teilweise oder vollständig trennt, der den Komparatoren (12) zugeführt wird, die in den Spalten-AD-Abschnitten (5) eingeschlossen sind, die den nicht zu betreibenden Spalten entsprechen.

10. Festkörperbildgebungseinrichtung (1) nach einem der Ansprüche 1 bis 7, wobei
die Spalten-AD-Abschnitte (5) Zähler (13) einschließen und
der Spaltenfreigabesteuerabschnitt (6) aufhört, einen Eingangstakt an die Zähler (13) zu liefern, die in den Spalten-AD-Abschnitten (5) eingeschlossen sind, die den nicht zu betreibenden Spalten entsprechen.

11. Verfahren zum Steuern einer Festkörperbildgebungseinrichtung (1) nach Anspruch 1, das Verfahren umfassend:
programmierbares Steuern von Operationen eines Spalten-AD-Abschnitts (5), der für jede der Spalten in einem Pixelarray-Abschnitt (3) gemäß einem Bildgebungsmodus angeordnet ist, und ferner umfassend
Steuern der Operationen der Spalten-AD-Abschnitte (5) gemäß einer Position eines interessierenden Bereichs des Bildgebungsmodus und wobei der interessierende Bereich einen Bereich, in dem eine Bewegung in einem Bewegungserfassungsmodus erfasst wird, einschließt oder einen Bereich, in dem eine Gesamtheit oder ein Teil eines menschlichen Körpers in einem Personenerfassungsmodus erfasst wird, einschließt und
Steuern der Operationen der Spalten-AD-Abschnitte (5) in dem Bewegungserfassungsmodus durch Ausdünnen von Pixeln in dem Pixelarray-Abschnitt (3) in Einheiten von Pixelblöcken in einer horizontalen Richtung, H-Richtung, und einer vertikalen Richtung, V-Richtung, wenn ausgelesen, und, wenn eine Bewegung in einem Bereich von einem oder mehreren Pixelblöcken erfasst wird, Einstellen dieses Pixelblocks als eine interessierende Region durch Betreiben der Spalten-AD Abschnitte (5), die den Spalten des interessierenden Bereichs entsprechen, während des Auslesens und durch Stoppen von Operationen der Spalten-AD-Abschnitte (5), die Spalten entsprechen, die andere als Spalten des interessierenden Bereichs sind, während des Auslesens des interessierenden Bereichs,
und
Steuern der Operationen der Spalten-AD-Abschnitte (5) in dem Personenerfassungsmodus durch Ausdünnen von Pixeln in dem Pixelarray-Abschnitt (3) in Einheiten einer vorbestimmten Anzahl von Spalten in der H-Richtung, wenn ausgelesen, und, wenn Gesichter mehrerer Personen erfasst werden, Einstellen mehrerer Bereiche, in denen Gesichter erfasst werden, durch Betreiben der Spalten-AD Abschnitte (5), die den Spalten des interessierenden Bereichs entsprechen, während des Auslesens und durch Stoppen von Operationen der Spalten-AD-Abschnitte (5), die Spalten entsprechen, die andere als Spalten der interessierenden Bereiche sind, während des Auslesens des interessierenden Bereichs als interessierende Bereiche.

12. Elektronische Vorrichtung (1200), umfassend:
Festkörperbildgebungseinrichtung (1) nach einem der Ansprüche 1 bis 10.

## Revendications

1. Appareil d'imagerie à semi-conducteur (1) comprenant :
une section de réseau de pixels (3) ;
une section de colonne AD (5) configurée pour être agencée pour chacune des colonnes dans la section de réseau de pixels (3) ; et
une section de commande d'activation de colonne (6) configurée pour commander de manière programmable des opérations des sections de colonne AD (5) conformément à un mode d'imagerie, dans lequel
la section de commande d'activation de colonne (6) est configurée pour commander les opérations des sections de colonne AD (5) conformément à une position d'une région d'intérêt du mode d'imagerie, et la région d'intérêt comporte une région dans laquelle un mouvement est détecté dans un mode de détection de mouvement ou comporte une région dans laquelle une totalité ou une partie d'un corps humain est détectée dans un mode de détection de personne, et
dans lequel la section de commande d'activation de colonne (6) est configurée pour commander les opérations des sections de colonne AD (5) dans le mode de détection de mouvement par dépressage de pixels dans la section de réseau de pixels (3) en unités de blocs de pixels dans une direction horizontale, H, et une direction verticale, V, lors de la lecture, et, lorsqu'un mouvement est détecté dans une région d'un ou de plusieurs blocs de pixels, définir ce bloc de pixels en tant que région d'intérêt par le fonctionnement des sections de colonne AD (5) correspondant à des colonnes de la région d'intérêt pendant la lecture, et par l'arrêt des opérations des sections de colonne AD (5) correspondant à des colonnes autres que des colonnes de la région d'intérêt pendant la lecture de la région d'intérêt,
la section de commande d'activation de colonne (6) étant en outre configurée pour commander les opérations des sections de colonne AD (5) dans le mode de détection de personne par dépressage de pixels de la section de réseau de pixels (3) en unités d'un nombre prédéterminé de colonnes dans la direction H lors de la lecture, et, lorsque des visages de plusieurs personnes sont détectés, définir de multiples régions dans lesquelles les visages sont détectés en tant que régions d'intérêt, par le fonctionnement des sections de colonne AD (5) correspondant à des colonnes de la région d'intérêt pendant la lecture, et par l'arrêt des opérations des sections de colonne AD (5) correspondant à des colonnes autres que des colonnes des régions d'intérêt pendant la lecture des régions d'intérêt.

2. Appareil d'imagerie à semi-conducteur (1) selon la revendication 1, dans lequel
la section de commande d'activation de colonne (6) commande la sortie d'un signal de fonctionnement pour faire fonctionner les sections de colonne AD (5) sur la base d'une pluralité de paramètres.

3. Appareil d'imagerie à semi-conducteur (1) selon la revendication 2, dans lequel
la pluralité de paramètres comporte un numéro de colonne de la colonne positionnée à une extrémité des colonnes consécutives ciblées pour lecture et un numéro de colonne de la colonne positionnée à son autre extrémité.

4. Appareil d'imagerie à semi-conducteur (1) selon la revendication 2 ou 3, dans lequel
la pluralité de paramètres comporte le nombre des colonnes consécutives non ciblées pour la lecture parmi les colonnes individuelles ciblées pour la lecture périodique.

5. Appareil d'imagerie à semi-conducteur (1) selon l'une quelconque des revendications 2 à 4, dans lequel
la pluralité de paramètres comporte le nombre de colonnes de la colonne à une extrémité des colonnes consécutives non ciblées partiellement pour la lecture, et le nombre de colonnes consécutives non ciblées partiellement pour la lecture.

6. Appareil d'imagerie à semi-conducteur (1) selon l'une quelconque des revendications 2 à 5, dans lequel
la section de commande d'activation de colonne (6) a des registres pour délivrer le signal de fonctionnement aux sections AD de colonne (5).

7. Appareil d'imagerie à semi-conducteur (1) selon l'une quelconque des revendications 2 à 5, dans lequel
la section de commande d'activation de colonne (6) a des registres à décalage comportant des bascules pour émettre le signal de fonctionnement vers les sections de colonne AD (5).

8. Appareil d'imagerie à semi-conducteur (1) selon l'une quelconque des revendications précédentes, dans lequel
les sections de colonne AD (5) comportent des transistors MOS de charge (11), et
la section de commande d'activation de colonne (6) coupe un courant fourni aux transistors MOS de charge (11) compris dans les sections de colonne AD (5) correspondant aux colonnes à ne pas faire fonctionner.

9. Appareil d'imagerie à semi-conducteur (1) selon l'une quelconque des revendications 1 à 7, dans lequel
les sections de colonne AD (5) comportent des comparateurs (12), et
la section de commande d'activation de colonne (6) coupe partiellement ou totalement un courant fourni aux comparateurs (12) compris dans les sections de colonne AD (5) correspondant aux colonnes à ne pas faire fonctionner.

10. Appareil d'imagerie à semi-conducteur (1) selon l'une quelconque des revendications 1 à 7, dans lequel
les sections de colonne AD (5) comportent des compteurs (13), et
la section de commande d'activation de colonne (6) arrête de fournir une horloge d'entrée aux compteurs (13) compris dans les sections de colonne AD (5) correspondant aux colonnes à ne pas faire fonctionner.

11. Procédé de commande d'un appareil d'imagerie à semi-conducteur (1) selon la revendication 1, le procédé comprenant :
la commander de manière programmable d'opérations d'une section de colonne AD (5) agencée pour chacune des colonnes dans une section de réseau de pixels (3) conformément à un mode d'imagerie, et comprenant en outre
la commande des opérations des sections de colonne AD (5) conformément à une position d'une région d'intérêt conformément au mode d'imagerie, et la région d'intérêt comporte une région dans laquelle un mouvement est détecté dans un mode de détection de mouvement ou comporte une région dans laquelle une totalité ou une partie d'un corps humain est détectée dans un mode de détection de personne, et
la commande des opérations des sections de colonne AD (5) dans le mode de détection de mouvement par dépressage de pixels dans la section de réseau de pixels (3) en unités de blocs de pixels dans une direction horizontale, H, et une direction verticale, V, lors de la lecture, et, lorsqu'un mouvement est détecté dans une région d'un ou de plusieurs blocs de pixels, la définition de ce bloc de pixels en tant que région d'intérêt par fonctionnement des sections de colonne AD (5) correspondant à des colonnes de la région d'intérêt pendant la lecture, et par l'arrêt des opérations des sections de colonne AD (5) correspondant à des colonnes autres que des colonnes de la région d'intérêt pendant la lecture de la région d'intérêt,
et
la commande des opérations des sections de colonne AD (5) dans le mode de détection de personne par dépressage de pixels de la section de réseau de pixels (3) en unités d'un nombre prédéterminé de colonnes dans la direction H lors de la lecture, et, lorsque des visages de plusieurs personnes sont détectés, la définition de multiples régions dans lesquelles les visages sont détectés en tant que régions d'intérêt, par fonctionnement des sections de colonne AD (5) correspondant à des colonnes des régions d'intérêt pendant la lecture et par arrêt des opérations des sections de colonne AD (5) correspondant à des colonnes autres que des colonnes des régions d'intérêt pendant la lecture des régions d'intérêt.

12. Dispositif électronique (1200) comprenant :
un appareil d'imagerie à semi-conducteur (1) selon l'une quelconque des revendications 1 à 10.
